# EUROPEAN PATENT APPLICATION

(11) **EP 3 389 038 A1**
(43) Date of publication of application: **17.10.2018**
(21) Application number: 16872586.9
(22) Date of filing: 28.10.2016
(51) Int. Cl.: G09G 3/32, G09G 3/20, H01L 33/00, H04B 10/116

(54) **IMAGE DISPLAY METHOD AND IMAGE DISPLAY DEVICE**

(30) Priority: 09.12.2015 JP 2015240670
(71) Applicant: Panasonic Intellectual Property Corporation of America, Torrance, CA 90503 (US)
(72) Inventor: MAEDA, Toshiyuki, Osaka-shi Osaka 540-6207 (JP); YAMAMOTO, Keita, Osaka-shi Osaka 540-6207 (JP); OSHIMA, Mitsuaki, Osaka-shi Osaka 540-6207 (JP); AOYAMA, Hideki, Osaka-shi Osaka 540-6207 (JP); SEKIBE, Tsutomu, Osaka-shi Osaka 540-6207 (JP); UEKI, Akihiro, Osaka-shi Osaka 540-6207 (JP); FUKUDOME, Tetsuya, Osaka-shi Osaka 540-6207 (JP); MAEZONO, Kensuke, Osaka-shi Osaka 540-6207 (JP)
(74) Representative: Grünecker Patent- und Rechtsanwälte PartG mbB
(86) International application number: PCT/JP2016/004740
(87) International publication number: WO 2017/098684

(57) **Abstract**

An aspect of the present disclosure, included are: a step S11 of obtaining picture signals and visible light signals; a step S12 of deciding a luminance change pattern by modulating the visible light signals; a step S13 of transmitting the visible light signals by performing luminance change of LEDs included in a panel in accordance with the luminance change pattern, in a first period that is a partial period of a frame display period; a step S14 of correcting a second gradient indicated by the picture signals, in accordance with a first gradient that is a gradient of the luminance change pattern of the first period, in a second period that follows the first period; and a step S15 of lighting the LEDs at the corrected second gradient in the second period.

## Description

### Technical Field

The present disclosure relates to a picture display method for displaying pictures, and so forth.

### Background Art

There conventionally has been proposed a picture display method where picture is displayed on a panel where LEDs (Light Emitting Diode) are arrayed in a matrix (LED panel) (e.g., see PTL 1). The gradient of light-emission luminance of the LEDs is adjusted by PWM control in this picture display method.

### Citation List

### Patent Literature

PTL 1: Japanese Unexamined Patent Application Publication No. 2012-227458

### Summary of Invention

However, the picture display method in the above PTL 1 has a problem that display of pictures and transmission of visible light signals cannot be appropriately performed.

Accordingly, the present disclosure provides a picture display method and so forth, where display of pictures and transmission of visible light signals can each be appropriately performed.

A picture display method according to an aspect of the present disclosure includes: a signal obtaining step of obtaining picture signals and visible light signals; a deciding step of deciding a luminance change pattern by modulating the visible light signals; a signal transmitting step of transmitting the visible light signals by performing luminance change of at least one light source out of a plurality of light sources included in a panel in accordance with the luminance change pattern, in a first period that is a partial period of a frame display period in which one frame of the picture signals is displayed; a correcting step of correcting a second gradient, which is a gradient of luminance of the light source indicated by the picture signals, in accordance with a first gradient that is a gradient of luminance of the light source expressed by the luminance change pattern of the first period, in a second period that is a partial period of the frame display period and follows the first period; and a picture lighting step of lighting the light source at the corrected second gradient in the second period.

It should be noted that these general or specific embodiments may be implemented as a system, a method, a device, an integrated circuit, a computer program, or a computer-readable recording medium such as a CD-ROM, and may be realized by any combination of a system, method, device, integrated circuit, computer program, and recording medium.

Accordingly, the picture display method according to the present disclosure can appropriately performed each of display of pictures and transmission of visible light signals.

### Brief Description of Drawings

[Fig. 1] Fig. 1 is a diagram illustrating a configuration of a picture display device assumed from a conventional picture display method, and an example of picture display on an LED panel of that picture display device.
[Fig. 2] Fig. 2 is a sequence diagram of signals and currents in the picture display device assumed from the conventional picture display method.
[Fig. 3] Fig. 3 is a block diagram illustrating a configuration example of a picture display device according to an embodiment.
[Fig. 4] Fig. 4 is a diagram illustrating an example of timings of signals used in the picture display device according to the embodiment.
[Fig. 5] Fig. 5 is a diagram illustrating the relation between slot width and pulse width of light ID in the embodiment.
[Fig. 6] Fig. 6 is a diagram for describing a lighting format of an LED panel in the embodiment.
[Fig. 7A] Fig. 7A is a diagram illustrating an example of timings of signals
and currents used in the picture display device according to the embodiment.
[Fig. 7B] Fig. 7B is a diagram illustrating the relation between slot width and pulse width applied to the example illustrated in Fig. 7A, according to the embodiment.
[Fig. 8] Fig. 8 is a diagram illustrating binarization of picture indicated by picture signals according to the embodiment.
[Fig. 9A] Fig. 9A is a diagram illustrating another example of timings of signals and currents used in the picture display device according to the embodiment.
[Fig. 9B] Fig. 9B is a diagram illustrating the relation between slot width and pulse width applied to the example illustrated in Fig. 9A.
[Fig. 10A] Fig. 10A is a diagram illustrating another example of timings of signals and currents used in the picture display device according to the embodiment.
[Fig. 10B] Fig. 10B is a diagram illustrating the relation between slot width and pulse width of control signals applied to the example illustrated in Fig. 10A, according to the embodiment.
[Fig. 10C] Fig. 10C is a diagram illustrating the relation between slot width and pulse width of drive signals applied to the example illustrated in Fig. 10A, according to the embodiment.
[Fig. 11A] Fig. 11A is a diagram illustrating the relation between an LED panel and picture signals according to the embodiment.
[Fig. 11B] Fig. 11B is a diagram illustrating an example of an LED panel configured of multiple LED units, according to the embodiment.
[Fig. 12] Fig. 12 is a diagram illustrating an example of a picture display method on the LED panel according to the embodiment.
[Fig. 13] Fig. 13 is a diagram illustrating another example of a picture display method on the LED panel according to the embodiment.
[Fig. 14] Fig. 14 is a diagram for describing an example of flickering suppression according to the embodiment.
[Fig. 15] Fig. 15 is a diagram for describing another example of flickering suppression according to the embodiment.
[Fig. 16] Fig. 16 is a diagram illustrating an example of timings at which luminance change occurs at the LED panel in accordance with light ID, in one frame display period, according to the embodiment.
[Fig. 17] Fig. 17 is a diagram illustrating another example of timings at which luminance change occurs at the LED panel in accordance with light ID, in one frame display period, according to the embodiment.
[Fig. 18] Fig. 18 is a diagram illustrating the relation between picture gradient, gradient of light ID, and picture gradient after correction, in a case where maximum picture gradient is 20, according to the embodiment.
[Fig. 19] Fig. 19 is a diagram illustrating an example of reducing wasteful periods from picture signal lighting periods according to the embodiment.
[Fig. 20A] Fig. 20A is a diagram illustrating the relation between picture gradient, gradient of light ID, and picture gradient after correction, in a case where maximum picture gradient is 26, according to the embodiment.
[Fig. 20B] Fig. 20B is a diagram illustrating the relation between picture gradient, gradient of light ID, and picture gradient after correction, in a case where maximum picture gradient is 26, according to the embodiment.
[Fig. 20C] Fig. 20C is a diagram illustrating the relation between picture gradient, gradient of light ID, and picture gradient after correction, in a case where maximum picture gradient is 26, according to the embodiment.
[Fig. 21A] Fig. 21A is a flowchart illustrating a picture display method according to an aspect of the present disclosure.
[Fig. 21B] Fig. 21B is a block diagram illustrating an example of a functional configuration of a picture display device according to an aspect of the present disclosure.

### Description of Embodiments

### (Underlying Knowledge Forming Basis of the Present Disclosure)

The Present Inventor has found that the following problem occurs with regard to the picture display method of PTL 1, listed in the "Background Art" section.

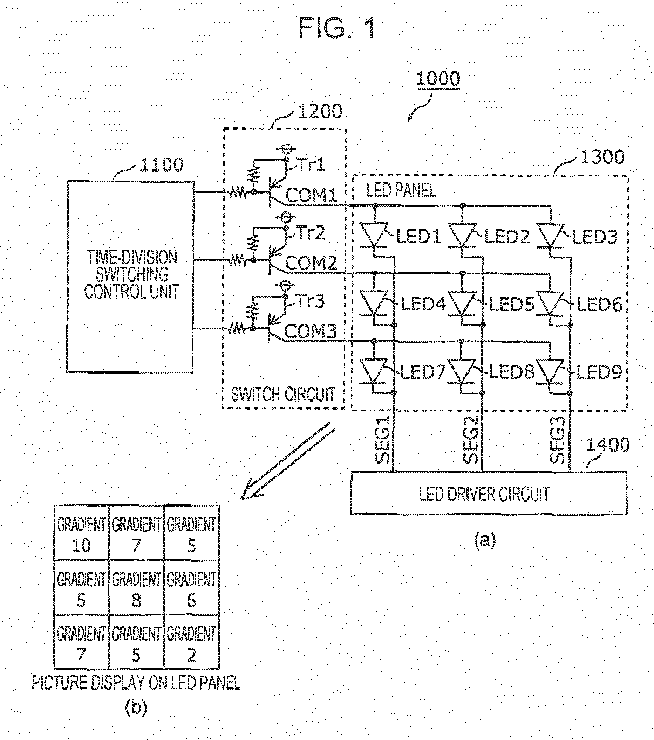

Fig. 1 is a diagram illustrating a configuration of a picture display device assumed from the picture display method of the aforementioned PTL 1, and an example of picture display on an LED panel of that picture display device.

As illustrated in (a) in Fig. 1, a picture display device 1000 has an LED panel 1300 that is a panel where LEDs 1 through 9 are arrayed in a matrix, a switch circuit 1200, a time-division switching control unit 1100, and an LED driver circuit 1400.

This picture display device 1000 displays pictures such as still images or moving images, by controlling the lighting state of the LEDs 1 through 9 of the LED panel 1300 by time-division control.

The switch circuit 1200 that drives in time-division is connected to one of the anode and cathode of the LEDs 1 through 9 of the LED panel 1300. The switch circuit 1200 has three transistors Tr1 through Tr3, which are each used as switches. Connected to the other of the LEDs 1 through 9 is the LED driver circuit 1400 configured as a constant current circuit.

The time-division switching control unit 1100 switches the transistors Tr1 through Tr3 of the switch circuit 1200 on and off in dime division. The LED driver circuit 1400 controls the current value flowing to LEDs to be light in accordance with picture signals at a timing that the transistors are on. Accordingly, the LEDs 1 through 9 can be lit with a luminance corresponding to the picture signals.

For example, the LED 1 can be lit at a luminance of gradient 10, and the LED 2 can be lit at a luminance of gradient 7, for example, as illustrated in (b) in Fig. 1.

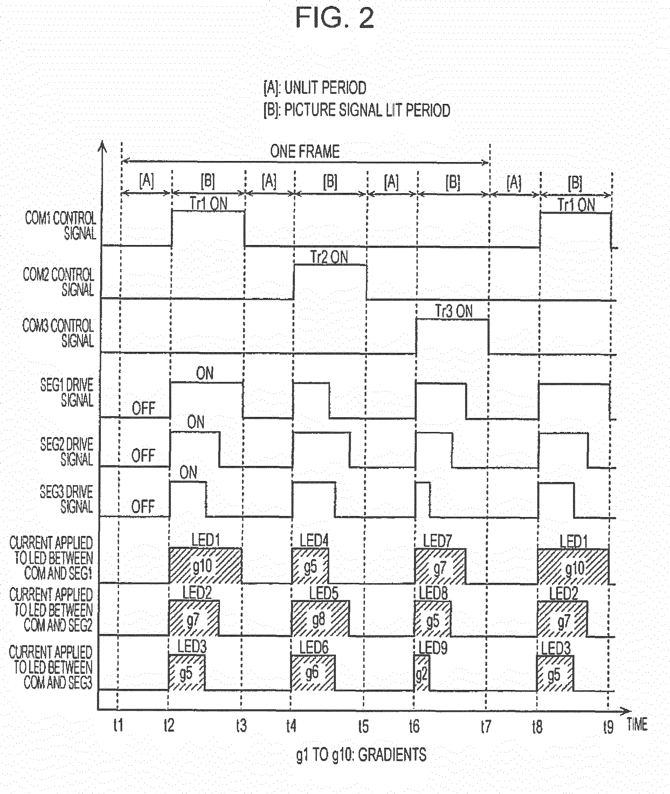

Fig. 2 is a diagram illustrating a sequence of signals and currents in the picture display device 1000.

For example, a period corresponding to one frame of picture signals is divided into three periods, for example, each of the three periods including an unlit period and a picture signal lit period. One frame is expressed by lighting of the LEDs 1 through 9 in the three picture signal lit periods.

In the picture signal lit period [B] (point-in-time t2 through t3) following the unlit period [A] (point-in-time t1 through t2), the time-division switching control unit 1100 sets a COM1 control signal for switching the transistor Tr1 to High. Accordingly, the transistor Tr1 goes on. At this time, the LED driver circuit 1400 switches SEG1 drive signal, SEG2 drive signal, and SEG3 drive signal, for controlling the LEDs 1 through 3 in accordance with picture signals, to ON Accordingly, current flows to the LED 1 (between COM1 and SEG1) in a period where the COM1 control signal is high, and also the SEG1 drive signal is ON, and the LED 1 is lit. The longer the period over which current flows to the LED 1 is, the higher the gradient of the luminance of the LED 1 is. That is to say, PWM control is performed. For example, the LED 1 is lit with luminance of gradient 10 (g10). In the same way, current flows to the LED 2 (between COM1 and SEG2) in a period where the COM1 control signal is high, and also the SEG2 drive signal is ON, and the LED 2 is lit with luminance of gradient 7 (g7). In the same way, current flows to the LED 3 (between COM1 and SEG3) in a period where the COM1 control signal is high, and also the SEG3 drive signal is ON, and the LED 3 is lit with luminance of gradient 5 (g5).

Next, after the picture signal lit period [B] (point-in-time t2 through t3) elapses, the time-division switching control unit 1100 switches the COM1 control signal to Low (L). Accordingly, the transistor Tr1 goes off, and all transistors Tr1 through Tr3 are off during the unlit period [A] (point-in-time t3 through t4). In the picture signal lit period [B] (point-in-time t4 through t5) after the unlit period [A] (point-in-time t3 through t4) has elapsed, the time-division switching control unit 1100 sets a COM2 control signal for switching the transistor Tr2 to High. Accordingly, the transistor Tr2 goes on. At this time, the LED driver circuit 1400 switches SEG1 drive signal, SEG2 drive signal, and SEG3 drive signal, for controlling the LEDs 4 through 6 in accordance with picture signals, to ON Accordingly, current flows to the LED 4 (between COM2 and SEG1) in a period where the COM2 control signal is high, and also the SEG1 drive signal is ON, and the LED 4 is lit with luminance of gradient 5 (g5), for example. In the same way, current flows to the LED 5 (between COM2 and SEG2) in a period where the COM2 control signal is high, and also the SEG2 drive signal is ON, and the LED 5 is lit with luminance of gradient 8 (g8), for example. In the same way, current flows to the LED 6 (between COM2 and SEG3) in a period where the COM2 control signal is high, and also the SEG3 drive signal is ON, and the LED 6 is lit with luminance of gradient 6 (g6), for example.

The picture display device 1000 then uses the COM3 control signal for switching the transistor Tr3 to perform the same processing as described above, thereby lighting the LEDs 7 through 9 with a luminance of gradient in accordance with the picture signals, during the picture signal lit period [B] (point-in-time t6 through t7).

Thus, the picture display device 1000 lights the LEDs corresponding to the control signals and drive signals in periods where the control signals such as the COM1 control signal, COM2 control signal, and COM3 control signal are High, and the drive signals such as the SEG1 drive signal, SEG2 drive signal, and SEG3 drive signal are ON.

Now, in order for this picture display device 1000 to perform not only picture display but also transmission of visible light signals, the LEDs 1 through 9 must be made to perform luminance change in accordance with the visible light signals. However, in a case of simply adding luminance of the visible light signals to the picture displayed on the LED panel 1300, the luminance per frame will increase. Accordingly, there is a problem that breakdown occurs in the display of the picture assumed by the picture signals.

In order to solve this problem, a picture display method according to an aspect of the present disclosure includes: a signal obtaining step of obtaining picture signals and visible light signals; a deciding step of deciding a luminance change pattern by modulating the visible light signals; a signal transmitting step of transmitting the visible light signals by performing luminance change of at least one light source out of a plurality of light sources included in a panel in accordance with the luminance change pattern, in a first period that is a partial period of a frame display period in which one frame of the picture signals is displayed; a correcting step of correcting a second gradient, which is a gradient of luminance of the light source indicated by the picture signals, in accordance with a first gradient that is a gradient of luminance of the light source expressed by the luminance change pattern of the first period, in a second period that is a partial period of the frame display period and follows the first period; and a picture lighting step of lighting the light source at the corrected second gradient in the second period. Note that the first period and second period are, for example, a light ID lit period and a picture signal lit period, and the light sources are LEDs. Also, the first gradient is a gradient or correction gradient of light ID for example, and the second gradient is a picture gradient for example.

For example, the lights sources included in the panel to display pictures are lit at a gradient of luminance in accordance with picture signals (second gradient). However, in a case where the light source has transmitted picture signals by luminance change before that, the pixel corresponding to that light source in the picture will appear to be lit at a strong luminance. As a result, breakdown of display of the picture assumed by the picture signals will occur. However, in the picture display method according to an aspect of the present disclosure, the second gradient is corrected in accordance with the gradient of luminance change (first gradient), and when displaying the picture, the light source is lit at the corrected second gradient, as described above. Accordingly, breakdown of picture such as described above can be suppressed. Accordingly, display of pictures and transmission of visible light can each be appropriately performed.

Also, an arrangement may be made where, in the signal transmitting step, out of the plurality of light sources included in the panel, a light source of which the second gradient indicated by the picture signal is lower than a threshold value gradient is not lit in the first period, and a light source of which the second gradient indicated by the picture signal is at the threshold value gradient or higher is caused to exhibit luminance change in the first period in accordance with the luminance change pattern.

According to this, only pixels displayed by picture signals of which the second gradient is the threshold value gradient or higher transmit visible light by luminance change in accordance with a luminance change pattern, so a situation where correction is impossible such as described above can be avoided. Further, when transmitting visible light signals, the panel displays an image that has been binarized by the threshold value gradient, and the bright region on the panel that transmits visible light signals can be broadened or narrowed by adjusting the threshold value gradient. For example, visible light signals can be transmitted from light sources where the second gradient is relatively low, i.e., dark, by lowering the threshold value gradient.

Also, an arrangement may be made where the gradient of luminance of each light source included in the panel is expressed in accordance with a lighting period over which the light source is lit, the second gradient is corrected by shortening the lighting period corresponding to the second gradient by a period corresponding to a lighting period corresponding to the first gradient in the correcting step, and the light source is lit for a lighting period corresponding to the shortened second gradient in the second period in the picture lighting step.

Accordingly, the second gradient can be appropriately corrected even in a case where the luminance of each light source in the panel is adjusted by PWM control.

For example, in the signal transmitting step, the light source may be caused to exhibit luminance change in accordance with the luminance change pattern by being lit at one of a first luminance and a second luminance that are different from each other, in increments of slots, during the first period, and when lighting the light source at the first luminance or the second luminance in the slot, the light source is lit for a period of the slot by causing the light source to repeatedly generate pulse light of a time width shorter than the slot.

The threshold value gradient may be higher than the first gradient. For example, the threshold value gradient may be 1.5 times the first gradient.

Accordingly, the second gradient can be prevented from becoming 0 even if the second gradient is corrected. Thus, the center of gravity of light emission based on change in luminance of a light source during the first period and lighting of the light source in the second period can be brought closer to the center of gravity of light emission of a case where the second gradient is lower than the threshold value gradient. As a result, in a case where the second gradient is unstable near the threshold value gradient, i.e., even in a case where the second gradient comes and goes between falling below the threshold value gradient and being at or above the threshold value gradient, occurrence of flickering due to fluctuation in the center of gravity of light emission.

Also, an arrangement may be made where, in the correcting step, in a case the light source being lit at multiple points in time in the second period, the second gradient is corrected at each of the plurality of points in time, and in the picture lighting step, the light source is lit at the corrected second gradient at each of the plurality of points in time.

Accordingly, the width of correction of the second gradient at each of the plurality of points in time (so-called loops) can be reduced, and influence of correction on picture display can be suppressed.

Also, in the correcting step, the second gradient may be corrected at each of the plurality of points in time by subtracting the same gradient from the second gradient at each of the plurality of points in time.

Accordingly, control of correction can be simplified.

Also, in the correcting step, the second gradient may be corrected at a first point in time and a second point in time out of the plurality of points in time, by subtracting n gradients (where n is an integer of 1 or greater) from the second gradient at the first point in time out of the plurality of points in time, and subtracting m gradients (where m is an integer of 1 or greater but smaller than n) from the second gradient at the second point in time that is farther from the first period than the first point in time.

Accordingly, n gradients are subtracted from the second gradient at a first point in time close to the first period, and m gradient, which are smaller than n gradients, are subtracted from the second gradient at a second point in time farther from the first period. Thus, the center of gravity of light emission based on change in luminance of a light source during the first period and lighting of the light source at the first and second points can be brought closer to the center of gravity of light emission of a case where the second gradient is lower than the threshold value gradient. As a result, in a case where the second gradient is unstable near the threshold value gradient, i.e., even in a case where the second gradient comes and goes between falling below the threshold value gradient and being at or above the threshold value gradient, occurrence of flickering due to fluctuation in the center of gravity of light emission.

An embodiment will be described in detail below with reference to the drawings.

Note that the embodiments described below are all specific examples of the technology of the present disclosure. Accordingly, values, shapes, materials, components, layout and connection state of the components, steps, the order of steps, and so forth illustrated in the following embodiments, are only exemplary, and are not intended to restrict the present disclosure. Components in the following embodiments which are not included in an independent Claim indicating a highest order concept are described as optional components.

### (Embodiment)

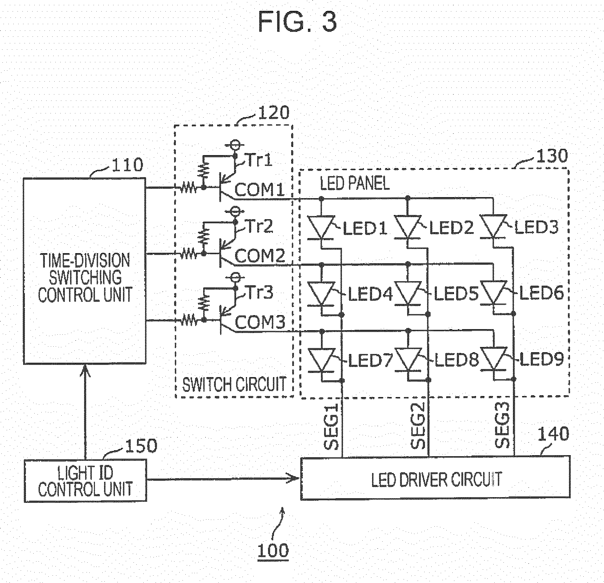

Fig. 3 is a block diagram illustrating a configuration of a picture display device 100 according to the present embodiment.

A picture display device 100 according to the present embodiment has, as illustrated in Fig. 3, an LED panel 130 that is a panel where LEDs 1 through 9 are arrayed in a matrix, a switch circuit 120, a time-division switching control unit 110, an LED driver circuit 140, and a light ID control unit 150.

This picture display device 100 displays pictures such as still images or moving images, by controlling the lighting state of the LEDs 1 through 9 of the LED panel 130 by time-division control.

The LED panel 130 has LEDs 1 through 9, which are light sources arrayed in a matrix, as described above. This LED panel 130 displays pictures by lighting or turning off the LEDs 1 through 9 as pixels. Note that although the LED panel 130 has nine LEDs in the example illustrated in Fig. 3, the number of LDS may be equal to or greater than nine.

The switch circuit 120 has three transistors Tr1 through Tr3, which are each used as switches. The bases of the three transistors Tr1 through Tr3 are connected to the time-division switching control unit 110. The collector (terminal COM1) of the transistor Tr1 is connected to the anodes, for example, of the LEDs 1 through 3. The collector (terminal COM2) of the transistor Tr2 is connected to the anodes, for example, of the LEDs 4 through 6. The collector (terminal COM3) of the transistor Tr3 is connected to the anodes, for example, of the LEDs 7 through 9.

The light ID control unit 150 obtains visible light signals, and modulates the visible light signals, thereby deciding a luminance change pattern. The light ID control unit 150 then outputs signals indicating the luminance change pattern to the time-division switching control unit 110. Note that visible light signals indicate an ID for identifying the picture display device 100 or the like, for example. Hereinafter, a luminance change pattern decided by modulating visible light signals, or signals indicating the luminance change patterns, will be referred to as a light ID. The light ID control unit 150 also outputs, to the LED driver circuit 140, correction signals to correct the picture signals in accordance with the light ID output to the time-division switching control unit 110.

The time-division switching control unit 110 switches the transistors Tr1 through Tr3 of the switch circuit 120 on or off in time division. That is to say, the time-division switching control unit 110 switches the transistors by switching control signals output to the transistors between High and Low. Specifically, the time-division switching control unit 110 switches the transistor Tr1 by switching the COM1 control signal output to the base of the transistor Tr1 between High and Low. In the same way, the time-division switching control unit 110 switches the transistor Tr2 by switching the COM2 control signal output to the base of the transistor Tr2 between High and Low. In the same way, the time-division switching control unit 110 switches the transistor Tr3 by switching the COM3 control signal output to the base of the transistor Tr3 between High and Low. Note that the control signals are not restricted to the example in Fig. 3 (COM1 control signal through COM3 control signal), and are generated in accordance with the number of transistors.

Also, upon receiving the light ID from the light ID control unit 150, the time-division switching control unit 110 switches one of the transistors Tr1 through Tr3 of the switch circuit 120 in accordance with that light ID.

The LED driver circuit 140 is configured as a constant current circuit, and has three terminals (terminals SEG1 through SEG3), for example. The terminal SEG1 is connected to, for example, the cathodes of the LEDs 1, 4, and 7, the terminal SEG2 is connected to, for example, the cathodes of the LEDs 2, 5, and 8, and the terminal SEG3 is connected to, for example, the cathodes of the LEDs 3, 6, and 9.

This LED driver circuit 140 obtains picture signals, and switches drive signals ON and OFF in accordance with the picture signals, thereby controlling electrical currents flowing to the LEDs connected to the terminals corresponding to the drive signals. Thus, the LED driver circuit 140 causes the LEDs to be lit in accordance with the picture signals. In other words, the LED driver circuit 140 has switches for lighting and turning off each of the LEDs 1 through 9. The LED driver circuit 140 switches the drives signals between ON and OFF in accordance with the picture signals, thereby switching the switches on and off, and causes the LEDs corresponding to the switches to be lit and turned off.

Specifically, the LED driver circuit 140 switches the SEG1 drive signal from OFF to ON in accordance with a picture signal. As a result, current flows to the LED connected to the collector of the transistor that is on, out of the LEDs 1, 4, and 7 connected to the terminal SEG1 corresponding to the SEG1 drive signal, and that LED is lit. In the same way, the LED driver circuit 140 switches the SEG2 drive signal from OFF to ON in accordance with a picture signal. As a result, current flows to the LED connected to the collector of the transistor that is on, out of the LEDs 2, 5, and 8 connected to the terminal SEG2 corresponding to the SEG2 drive signal, and that LED is lit. In the same way, the LED driver circuit 140 switches the SEG3 drive signal from OFF to ON in accordance with a picture signal. As a result, current flows to the LED connected to the collector of the transistor that is on, out of the LEDs 3, 6, and 9 connected to the terminal SEG3 corresponding to the SEG3 drive signal, and that LED is lit. Note that the drive signals are not restricted to the example in Fig. 3 (SEG1 drive signal through SEG3 drive signal), and are generated in accordance with the number of LEDs.

The LED driver circuit 140 expresses the gradient of luminance of each LED included in the LED panel 130 in accordance with a lighting period over which that LED is lit. That is to say, the LED driver circuit 140 performs PWM control on each LED. Accordingly, each of the LEDs 1 through 9 of the LED panel 130 can be made to be lit with a luminance corresponding to the picture signals. Also, upon receiving correction signals from the light ID control unit 150, the LED driver circuit 140 shortens, in accordance with the correction signals, the time over which the drive signals should be ON in accordance with the picture signals.

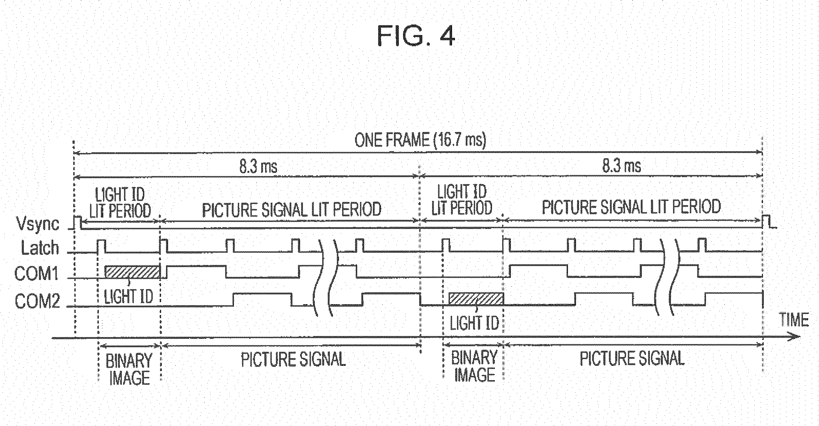

Fig. 4 is a diagram illustrating an example of timing of the signals used in the picture display device 100 according to the present embodiment.

For example, one frame of a picture signal is expressed in a period (frame display period) of 16. ms. This frame display period is also divided into two periods (e.g., 8.3 ms), for example, and the two periods include a light ID lit period (first period) and a picture signal lit period (second period). One frame is expressed by lighting of the LEDs 1 through 9 in the two light ID lit periods and picture signal lit periods in the frame display period. Note that an arrangement may be made where the frame display period is not split, and one frame is expressed by lighting of the LEDs 1 through 9 in one light ID lit period and picture signal lit period in the frame display period. Alternatively, the frame display period may be divided into three or more periods, with the three or more periods each including a light ID lit period and picture signal lit period.

The time-division switching control unit 110 switches the COM1 control signal, COM2 control signal, and COM3 control signal between High and Low, based on a Vsync signal (vertical synchronizing signal) and Latch signal. Note that the COM3 control signal is omitted from Fig. 4 to facilitate description. The number of control signals is not restricted to three, and control signals of a number corresponding to the number of transistors is generated.

The time-division switching control unit 110 switches the COM1 control signal to High and Low in accordance with the light ID in the light ID lit period, thereby switching the transistor Tr1, as illustrated in Fig. 4. During this light ID lit period, the LED driver circuit 140 turns the SEG1 drive signal, SEG2 drive signal, and SEG2 drive signal to ON. As a result, the LEDs 1 through 3 are caused to change luminance in accordance with the light ID, and visible light can be transmitted.

Now, during the light ID lit period, the LED driver circuit 140 only turns ON the drive signal corresponding to an LED, with regard to an LED of which the gradient of luminance indicated by the picture signal is a gradient threshold value or higher. Hereinafter, the gradient of luminance indicated by picture signals will be referred to as picture gradient (second gradient). Accordingly, out of the multiple LEDs included in the LED panel 130, only the LEDs of which the picture gradient is the threshold value gradient or higher change luminance in accordance with the light ID.

That is to say, the LED driver circuit 140 does not light LEDs of which the second gradient indicated by picture signals is lower than the threshold value gradient, out of the multiple LEDs included in the LED panel 130, and causes the LEDs of which the second gradient indicated by picture signals is the threshold value gradient or higher to change luminance in accordance with a luminance change pattern in the first period.

As a result, an image binarized in accordance with the threshold value gradient (binarized image) is displayed in the light ID lit period.

Also, in the picture signal lit period, the time-division switching control unit 110 performs time-division control of alternately switching the COM1 control signal and COM2 control signal to High or Low. In the picture signal lit period, the LED driver circuit 140 switches the SEG1 drive signal, SEG2 drive signal, and SEG3 drive signal ON in accordance with picture signals. Thus, LEDs corresponding to High control signals are lit in accordance with drive signals corresponding to picture signals. As a result, picture corresponding to the picture signals is displayed on the LED panel 130.

Now, upon having received correction signals from the light ID control unit 150, the LED driver circuit 140 shortens the period for the drive signals to be ON in accordance with the picture signals, but a period in accordance with the correction signals. That is to say, the LED driver circuit 140 corrects the picture gradient by shortening the lit period corresponding to the picture gradient (second gradient) by a lit period corresponding to a first gradient. Note that the first gradient is a gradient of luminance of the LED expressed by a luminance change pattern of the light ID lit period (first period). This first gradient is indicated by correction signals. In the picture signal lit period (second period), the LED driver circuit 140 causes the LED to be lit for a lighting period corresponding to the shortened picture gradient (second gradient).

Accordingly, even in a case where the gradient of luminance increases in the light ID lit period due to transmission of visible light signals, increase in the gradient of luminance during the frame display period can be suppressed. As a result, breakdown in picture display can be suppressed. Also, the picture gradient (second gradient) can be appropriately corrected in a case where the gradient of luminance of each LED in the LED panel 130 is adjusted by PWM control.

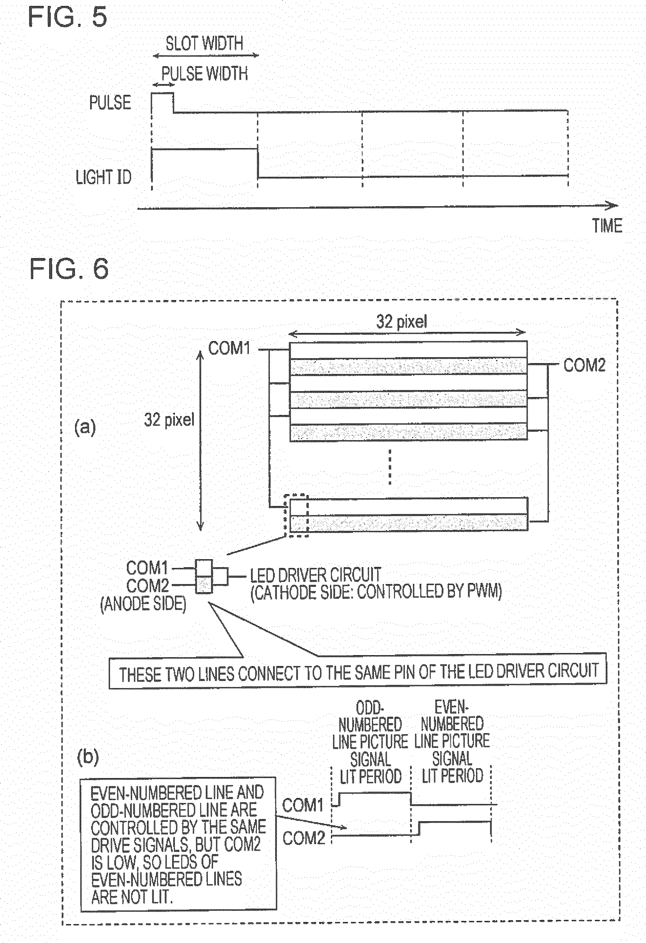

Fig. 5 is a diagram illustrating the relation between the slot width and pulse width of light ID.

A light ID is generated by modulating visible light signals by 4-pulse position modulation (4PPM) for example. Accordingly, the light ID indicates High or Low in each of four slots representing one symbol, as illustrated in Fig. 5. The width of one of these slots (slot width) is 104 µs, for example. Each LED of the LED panel 130 can be lit by 5 µs widths, for example by current applied by the time-division switching control unit 110 and LED driver circuit 140. That is to say, the time-division switching control unit 110 and LED driver circuit 140 can light the LES with pulse widths sufficiently shorter than the slot width.

That is to say, in the light ID lit period (first period), the time-division switching control unit 110 according to the present embodiment can cause luminance change of LEDs in accordance with a luminance change pattern, by lighting the LEDs with a luminance of one of a first luminance and a second luminance that differ from each other, in increments of slots. Now, when lighting LEDs with the first luminance or the second luminance in a slot, the time-division switching control unit 110 lights the LEDs for the period of the slot, by causing the LED to repeatedly emit pulse light of a time width that is shorter than the slot. Accordingly, the duty ratio in a 4PPM light ID can be optionally set.

Fig. 6 is a diagram for describing the lighting format of the LED panel 130.

The LED panel 130 is made up of a first light having the LEDs 1 through 3, a second line having the LEDs 4 through 6, and a third line having the LEDs 7 through 9, as described above. However, the LED panel 130 according to the present embodiment may be configured of multiple odd-numbered lines and multiple even-numbered lines, as illustrated in (a) in Fig. 6. The multiple odd-numbered lines are made up of multiple LEDs arrayed in one row in the horizontal direction, with the LEDS included in the multiple odd-numbered lines each being connected to a common transistor within the switch circuit 120, and controlled by the COM1 control signals of that transistor. In the same way, the multiple even-numbered lines are made up of multiple LEDs arrayed in one row in the horizontal direction, with the LEDS included in the multiple even-numbered lines each being connected to a common transistor within the switch circuit 120, and controlled by the COM2 control signals of that transistor. The odd-numbered lines are lines that are odd-numbered from the upper end of the LED panel 130 in the vertical direction, and the even-numbered lines are lines that are even-numbered from the upper end of the LED panel 130 in the vertical direction.

For example, the anode of each LED in the multiple odd-numbered lines is connected to the collector (terminal COM1) of the transistor Tr1 of the switch circuit 120, and the anode of each LED in the multiple even-numbered lines is connected to the collector (terminal COM2) of the transistor Tr2 of the switch circuit 120. Further, the cathodes of the multiple LEDs arrayed in one row in the vertical direction of the LED panel 130 are connected to the same pin (terminal) of the LED driver circuit 140.

Note that the multiple LEDs arrayed in one row in the vertical direction of the LED panel 130 are controlled by a common drive signal of the LED driver circuit 140. However, during the picture signal lit period of odd-numbered lines, the COM1 control signal is High, and the COM2 control signal is low, as illustrated in (b) in Fig. 6. Accordingly, out of the multiple LEDs arrayed in the vertical direction, the LEDs in the odd-numbered lines are lit at a luminance in accordance with drive signals, while the LEDs in the even-numbered lines are not lit.

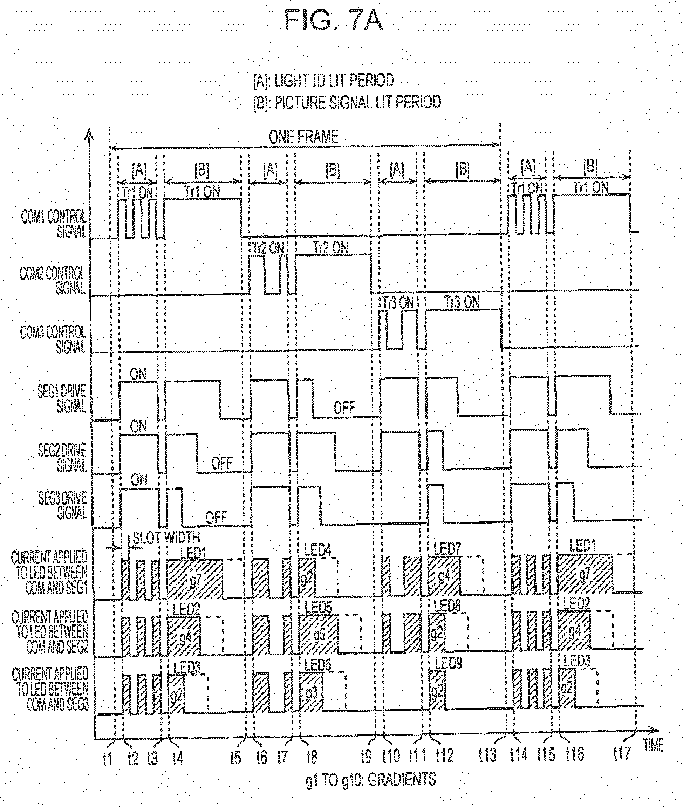

Fig. 7A is a diagram illustrating an example of timings of the signals and the currents used in the picture display device 100 according to the present embodiment.

For example, a period for expressing one frame of picture signals (frame display period) is divided into three periods, with the three periods each including a light ID lit period [A] and picture signal lit period [B]. One frame is expressed by lighting of the LEDs 1 through 9 during the three light ID lit periods [A] and three picture signal lit period [B] in the frame display period.

During the light ID lit period [A] (point-in-time t2 through t3), the time-division switching control unit 110 switches, out of the COM1 control signal through COM3 control signal, only the COM1 control signal, between High and Low in accordance with the light ID. The COM1 control signal is a control signal for switching the transistor Tr1 on and off. As a result, only the transistor Tr1 in the switch circuit 120 is switched between on and off according to the light ID, during the light ID lit period [A] (point-in-time t2 through t3).

At this time, during the light ID lit period [A] (point-in-time t2 through t3), the LED driver circuit 140 turns ON the SEG1 drive signal, SEG2 drive signal, and SEG3 drive signal, to control the LEDs 1 through 3. Accordingly, during a period where the COM1 control signal is High and the SEG1 drive signal is ON, current flows to the LED 1 (between COM1 and SEG1), and the LED 1 is lit. In the same way, during a period where the COM1 control signal is High and the SEG2 drive signal is ON, current flows to the LED 2 (between COM1 and SEG2), and the LED 2 is lit. In the same way, during a period where the COM1 control signal is High and the SEG3 drive signal is ON, current flows to the LED 3 (between COM1 and SEG3), and the LED 3 is lit. Thus, during the light ID lit period [A] (point-in-time t2 through t3) the LEDs 1 through 3 transmit visible light signals by luminance change in accordance with the light ID.

In this way, the picture display device 100 according to the present embodiment transmits visible light signals by causing luminance change of at least one light source out of the multiple LEDs included in the LED panel 130 in accordance with a luminance change pattern, in a certain first period that is a partial period of a frame display period for display of one frame of picture signals.

Further, during the picture signal lit period [B] (point-in-time t4 through t5) following the light ID lit period [A] (point-in-time t2 through t3), the time-division switching control unit 110 switches, out of the COM1 control signal through COM3 control signal, only the COM1 control signal, to High. As a result, the transistor Tr1 turns on. At this time, the LED driver circuit 140 turns ON the SEG1 drive signal, SEG2 drive signal, and SEG3 drive signal, for controlling the LEDs 1 through 3, in accordance with picture signals. Note that the order of the light ID lit period [A] and picture signal lit period [B] in the frame display period is not restricted to that in the example in Fig. 7A, and that the light ID lit period [A] may be provided after the picture signal lit period [B].

Now, the light ID control unit 150 according to the present embodiment generates correction signals for lowering the gradient of luminance of the picture signals during the picture signal lit period [B] (point-in-time t4 through t5). That is to say, the light ID control unit 150 generates correction signals for lowering the gradient of luminance of the picture signals by an amount corresponding to a gradient of luminance representing the light ID (first luminance) during the immediately-previous light ID lit period [A] (point-in-time t2 through t3). The light ID control unit 150 then outputs the correction signals to the LED driver circuit 140. The LED driver circuit 140 controls the luminance of the LEDs by PWM, using drive signals. Accordingly, in the picture signal lit period [B] (point-in-time t4 through t5), the LED driver circuit 140 reduces the period of the drive signals being ON in accordance with the picture signals, according to the correction signals.

For example, in a case where the LEDs 1 through 3 are lit by a period equivalent to the luminance of gradient 3 in accordance with the light ID in light ID lit period [A] (point-in-time t2 through t3), the light ID control unit 150 outputs correction signals indicating gradient 3 to the LED driver circuit 140. Note that the gradient indicated by correction signals hereinafter will be referred to as correction gradient. If the picture gradient of the LED 1 is 10 in the picture signal lit period [B] (point-in-time t4 through t5), the LED driver circuit 140 subtracts the correction gradient 3 from the picture gradient 10. As a result, the LED driver circuit 140 turns the SEG1 drive signal ON by a period corresponding to gradient 7 (picture gradient 10 minus correction gradient 3) during the picture signal lit period [B] (point-in-time t4 through t5). In the same way, if the picture gradient of the LED 2 is 7 in the picture signal lit period [B] (point-in-time t4 through t5), the LED driver circuit 140 subtracts the correction gradient 3 from the picture gradient 7. As a result, the LED driver circuit 140 turns the SEG2 drive signal ON by a period corresponding to gradient 4 (picture gradient 7 minus correction gradient 3) during the picture signal lit period [B] (point-in-time t4 through t5). In the same way, if the picture gradient of the LED 3 is 5 in the picture signal lit period [B] (point-in-time t4 through t5), the LED driver circuit 140 subtracts the correction gradient 3 from the picture gradient 5. As a result, the LED driver circuit 140 turns the SEG3 drive signal ON by a period corresponding to gradient 2 (picture gradient 5 minus correction gradient 3) during the picture signal lit period [B] (point-in-time t4 through t5).

In this way, in the picture signal lit period (second period) following the light ID lit period (first period) that is a partial period of the frame display period, the LED driver circuit 140 according to the present embodiment corrects the picture gradient (second gradient) that is the gradient of luminance of the LEDs indicated by picture signals in accordance with the first gradient that is the gradient of luminance of the LEDs expressed by a luminance change pattern of the light ID lit period. Note that the light ID lit period (first period) may be provided after the picture signal lit period (second period). In this case as well, the picture gradient (second gradient) that is the gradient of luminance of the LEDs indicated by picture signals is corrected in accordance with the first gradient that is the gradient of luminance of the LEDs expressed by a luminance change pattern of the light ID lit period.

Accordingly, during a period where the COM1 control signal is High and the SEG1 drive signal is ON, current flows to the LED 1 (between COM1 and SEG1), and the LED 1 is lit at luminance of gradient 7 (g7). In the same way, during a period where the COM1 control signal is High and the SEG2 drive signal is ON, current flows to the LED 2 (between COM1 and SEG2), and the LED 2 is lit at luminance of gradient 4 (g4). In the same way, during a period where the COM1 control signal is High and the SEG3 drive signal is ON, current flows to the LED 3 (between COM1 and SEG3), and the LED 3 is lit at luminance of gradient 2 (g2).

Thus, the LED driver circuit 140 according to the present embodiment lights the LEDs at the corrected picture gradient (second gradient) in the picture signal lit period (second period).

Note that the picture display device 100 according to the present embodiment performs PWM control to raise the luminance of LEDs by lengthening the period of currents flowing to these LEDs, and lower the luminance of LEDs by shortening the period of currents flowing to these LEDs.

The picture display device 100 performs processing the same as that described above in the light ID lit period [A] (point-in-time t6 through t7) and picture signal lit period [B] (point-in-time t8 through t9) following this picture signal lit period [B] (point-in-time t4 through t5) as well.

Specifically, during the light ID lit period [A] (point-in-time t6 through t7), the time-division switching control unit 110 switches, out of the COM1 control signal through COM3 control signal, only the COM2 control signal, between High and Low in accordance with the light ID. The COM2 control signal is a control signal for switching the transistor Tr2 on and off. As a result, only the transistor Tr2 in the switch circuit 120 is switched between on and off according to the light ID, during the light ID lit period [A] (point-in-time t6 through t7).

At this time, during the light ID lit period [A] (point-in-time t6 through t7), the LED driver circuit 140 turns ON the SEG1 drive signal, SEG2 drive signal, and SEG3 drive signal, to control the LEDs 4 through 6. Accordingly, during a period where the COM2 control signal is High and the SEG1 drive signal is ON, current flows to the LED 4 (between COM2 and SEG1), and the LED 4 is lit. In the same way, during a period where the COM2 control signal is High and the SEG2 drive signal is ON, current flows to the LED 5 (between COM2 and SEG2), and the LED 5 is lit. In the same way, during a period where the COM2 control signal is High and the SEG3 drive signal is ON, current flows to the LED 6 (between COM2 and SEG3), and the LED 6 is lit. Thus, during the light ID lit period [A] (point-in-time t6 through t7), the LEDs 4 through 6 transmit visible light signals by luminance change in accordance with the light ID.

Further, during the picture signal lit period [B] (point-in-time t8 through t9) following the light ID lit period [A] (point-in-time t6 through t7), the time-division switching control unit 110 switches, out of the COM1 control signal through COM3 control signal, only the COM2 control signal, to High. As a result, the transistor Tr2 turns on. At this time, the LED driver circuit 140 turns ON the SEG1 drive signal, SEG2 drive signal, and SEG3 drive signal, to control the LEDs 4 through 6, in accordance with picture signals.

Now, the light ID control unit 150 according to the present embodiment generates correction signals for lowering the gradient of luminance of the picture signals during the picture signal lit period [B] (point-in-time t8 through t9), in the same way as described above. That is to say, the light ID control unit 150 generates correction signals for lowering the gradient of luminance of the picture signals by an amount corresponding to a gradient of luminance representing the light ID during the immediately-previous light ID lit period [A] (point-in-time t6 through t7). The light ID control unit 150 then outputs the correction signals to the LED driver circuit 140. The LED driver circuit 140 controls the luminance of the LEDs by PWM, using drive signals. Accordingly, in the picture signal lit period [B] (point-in-time t8 through t9), the LED driver circuit 140 reduces the period of the drive signals being ON in accordance with the picture signals, according to the correction signals.

For example, in a case where the LEDs 4 through 6 are lit by a period equivalent to the luminance of gradient 3 in accordance with the light ID in light ID lit period [A] (point-in-time t6 through t7), the light ID control unit 150 outputs correction signals indicating gradient 3 to the LED driver circuit 140. If the picture gradient of the LED 4 is 5 in the picture signal lit period [B] (point-in-time t8 through t9), the LED driver circuit 140 subtracts the correction gradient 3 from the picture gradient 5. As a result, the LED driver circuit 140 turns the SEG1 drive signal ON by a period corresponding to gradient 2 (picture gradient 5 minus correction gradient 3) during the picture signal lit period [B] (point-in-time t8 through t9). In the same way, if the picture gradient of the LED 5 is 8 in the picture signal lit period [B] (point-in-time t8 through t9), the LED driver circuit 140 subtracts the correction gradient 3 from the picture gradient 8. As a result, the LED driver circuit 140 turns the SEG2 drive signal ON by a period corresponding to gradient 5 (picture gradient 8 minus correction gradient 3) during the picture signal lit period [B] (point-in-time t8 through t9). In the same way, if the picture gradient of the LED 6 is 6 in the picture signal lit period [B] (point-in-time t8 through t9), the LED driver circuit 140 subtracts the correction gradient 3 from the picture gradient 6. As a result, the LED driver circuit 140 turns the SEG3 drive signal ON by a period corresponding to gradient 3 (picture gradient 6 minus correction gradient 3) during the picture signal lit period [B] (point-in-time t8 through t9).

Accordingly, during a period where the COM2 control signal is High and the SEG1 drive signal is ON, current flows to the LED 4 (between COM2 and SEG1), and the LED 4 is lit at luminance of gradient 2 (g2). In the same way, during a period where the COM2 control signal is High and the SEG2 drive signal is ON, current flows to the LED 5 (between COM2 and SEG2), and the LED 5 is lit at luminance of gradient 5 (g5). In the same way, during a period where the COM2 control signal is High and the SEG3 drive signal is ON, current flows to the LED 6 (between COM2 and SEG3), and the LED 6 is lit at luminance of gradient 3 (g3).

The picture display device 100 performs processing the same as described above in the light ID lit period [A] (point-in-time t10 through t11) and picture signal lit period [B] (point-in-time t12 through t13), after the picture signal lit period [B] (point-in-time t8 through t9) has elapsed.

However, in the present embodiment, in a case where the picture gradient (second gradient) of an LED is lower than the correction gradient (first gradient), the LED driver circuit 140 does not turn the drive signal corresponding to that LED, but rather OFF during the light ID lit period. That is to say, the LED driver circuit 140 does not cause that LED to perform luminance change to transmit visible light signals. Further, the LED driver circuit 140 does not perform correction in accordance with correction signals regarding the picture gradient of that LED during the picture signal lit period. That is to say, the LED driver circuit 140 does not perform correction in accordance with correction signals regarding the period of the drive singals corresponding to that LED being ON in accordance with picture signals.

Specifically, during the light ID lit period [A] (point-in-time t10 through t11), the time-division switching control unit 110 switches, out of the COM1 control signal through COM3 control signal, only the COM3 control signal, between High and Low in accordance with the light ID. This COM3 control signal is a control signal for switching the transistor Tr3 on and off. As a result, only the transistor Tr3 in the switch circuit 120 is switched between on and off according to the light ID, during the light ID lit period [A] (point-in-time t10 through t11).

At this time, during the light ID lit period [A] (point-in-time t10 through t11), the LED driver circuit 140 turns ON the SEG1 drive signal and SEG2 drive signal, to control the LEDs 7 and 8.

On the other hand, the LED driver circuit 140 turns OFF the SEG3 drive signal that controls the LED 9. The picture gradient (e.g., second gradient) of the LED 9 is lower than the correction gradient (e.g., third gradient), so the LED driver circuit 140 turns OFF the SEG3 drive signal that controls the LED 9, as described above.

Accordingly, during a period where the COM3 control signal is High and the SEG1 drive signal is ON, current flows to the LED 7 (between COM3 and SEG1), and the LED 7 is lit. In the same way, during a period where the COM3 control signal is High and the SEG2 drive signal is ON, current flows to the LED 8 (between COM3 and SEG2), and the LED 8 is lit. Thus, during the light ID lit period [A] (point-in-time t10 through t11), only the LEDs 7 and 8 out of the LEDs 7 through 9 transmit visible light signals by luminance change in accordance with the light ID.

Further, during the picture signal lit period [B] (point-in-time t12 through t13) following the light ID lit period [A] (point-in-time t10 through t11), the time-division switching control unit 110 switches, out of the COM1 control signal through COM3 control signal, only the COM3 control signal, to High. As a result, the transistor Tr3 turns on. At this time, the LED driver circuit 140 turns ON the SEG1 drive signal, SEG2 drive signal, and SEG3 drive signal, for controlling the LEDs 7 through 9, in accordance with picture signals.

Now, the light ID control unit 150 according to the present embodiment generates correction signals for lowering the gradient of luminance of the picture signals during the picture signal lit period [B] (point-in-time t12 through t13). That is to say, the light ID control unit 150 generates correction signals for lowering the gradient of luminance of the picture signals by an amount corresponding to a gradient of luminance representing the light ID during the immediately-previous light ID lit period [A] (point-in-time t10 through t11). The light ID control unit 150 then outputs the correction signals to the LED driver circuit 140. The LED driver circuit 140 controls the luminance of the LEDs by PWM, using drive signals. Accordingly, in the picture signal lit period [B] (point-in-time t12 through t13), the LED driver circuit 140 reduces the period of the drive signals being ON in accordance with the picture signals, according to the correction signals.

For example, in a case where the LEDs 7 and 8 are lit by a period equivalent to the luminance of gradient 3 in accordance with the light ID in light ID lit period [A] (point-in-time t10 through t11), the light ID control unit 150 outputs correction signals indicating gradient 3 to the LED driver circuit 140. If the picture gradient of the LED 7 is 7 in the picture signal lit period [B] (point-in-time t12 through t13), the LED driver circuit 140 subtracts the correction gradient 3 from the picture gradient 7. As a result, the LED driver circuit 140 turns the SEG1 drive signal ON by a period corresponding to gradient 4 (picture gradient 7 minus correction gradient 3) during the picture signal lit period [B] (point-in-time t12 through t13). In the same way, if the picture gradient of the LED 8 is 5 in the picture signal lit period [B] (point-in-time t12 through t13), the LED driver circuit 140 subtracts the correction gradient 3 from the picture gradient 5. As a result, the LED driver circuit 140 turns the SEG2 drive signal ON by a period corresponding to gradient 2 (picture gradient 5 minus correction gradient 3) during the picture signal lit period [B] (point-in-time t12 through t13).

On the other hand, if the picture gradient of the LED 9 is 2 in the picture signal lit period [B] (point-in-time t12 through t13), the LED driver circuit 140 judges that the picture gradient 2 is lower than the correction gradient 3. At this time, the LED driver circuit 140 turns the SEG3 drive signal ON by a period corresponding to the picture gradient 2 of the LED 9 in the picture signal lit period [B] (point-in-time t12 through t13). That is to say, the LED driver circuit 140 does not correct in accordance with the correction signal the period for turning the drive signal ON in accordance with the picture signal.

Accordingly, during a period where the COM3 control signal is High and the SEG1 drive signal is ON, current flows to the LED 7 (between COM3 and SEG1), and the LED 7 is lit at luminance of gradient 4 (g4). In the same way, during a period where the COM3 control signal is High and the SEG2 drive signal is ON, current flows to the LED 8 (between COM3 and SEG2), and the LED 8 is lit at luminance of gradient 2 (g2). In the same way, during a period where the COM3 control signal is High and the SEG3 drive signal is ON, current flows to the LED 9 (between COM3 and SEG3), and the LED 9 is lit at luminance of gradient 2 (g2).

Thus, the picture display method according to the present embodiment includes: a signal obtaining step of obtaining picture signals and visible light signals; a deciding step of deciding a luminance change pattern by modulating the visible light signals; a signal transmitting step of transmitting the visible light signals by performing luminance change of at least one light source out of a plurality of light sources included in a panel in accordance with the luminance change pattern, in a first period that is a partial period of a frame display period in which one frame of the picture signals is displayed; a correcting step of correcting a second gradient, which is a gradient of luminance of the light source indicated by the picture signals, in accordance with a first gradient that is a gradient of luminance of the light source expressed by the luminance change pattern of the first period, in a second period that is a partial period of the frame display period and follows the first period; and a picture lighting step of lighting the light source at the corrected second gradient in the second period.

Accordingly, the second gradient is corrected in accordance with the first gradient, and when displaying the picture, the light source is lit at the corrected second gradient. Accordingly, breakdown of pictures such as described above can be suppressed. Thus, display of pictures and transmission of visible light signals can each be appropriately performed.

Also, in a case where the picture gradient of an LED is lower than the correction gradient, that LED is not caused to perform luminance change in accordance with the light ID in the present embodiment, as described above. That is to say, in a case where the picture gradient of an LED is lower than the threshold value gradient, no visible light signal is transmitted from that LED.

In other words, the picture display device 100 according to the present embodiment binarizes picture displayed by picture signals using the above-described threshold value gradient during the light ID lit period. The picture display device 100 then causes luminance change following a light ID at, out of multiple LEDs included in the LED panel 130, only the LEDs at regions where the binarized picture is bright.

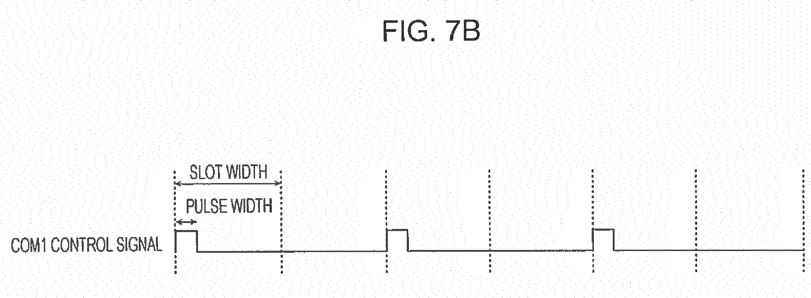

Fig. 7B is a diagram illustrating the relation between slot width and pulse width, applied to the example illustrated in Fig. 7A.

In a case of the picture display device 100 controlling the signals and currents in accordance with the timings illustrated in Fig. 7A as well, the time-division switching control unit 110 may light the LEDs in the same way as the example illustrated in Fig. 5. That is to say, the time-division switching control unit 110 lights LEDs corresponding to the COM1 control signal by switching the COM1 control signal between High and Low, for example, as illustrated in Fig. 7B. At this time, the time-division switching control unit 110 lights the LEDs for the period of that slot by causing the LEDs to repeatedly emit pulse light of a time width shorter than the slot. This enables the duty ratio to be optionally set for light ID in 4PPM. Note that the time-division switching control unit 110 performs switching in the same way as the COM1 control signal regarding the COM2 control signal and COM3 control signal as well.

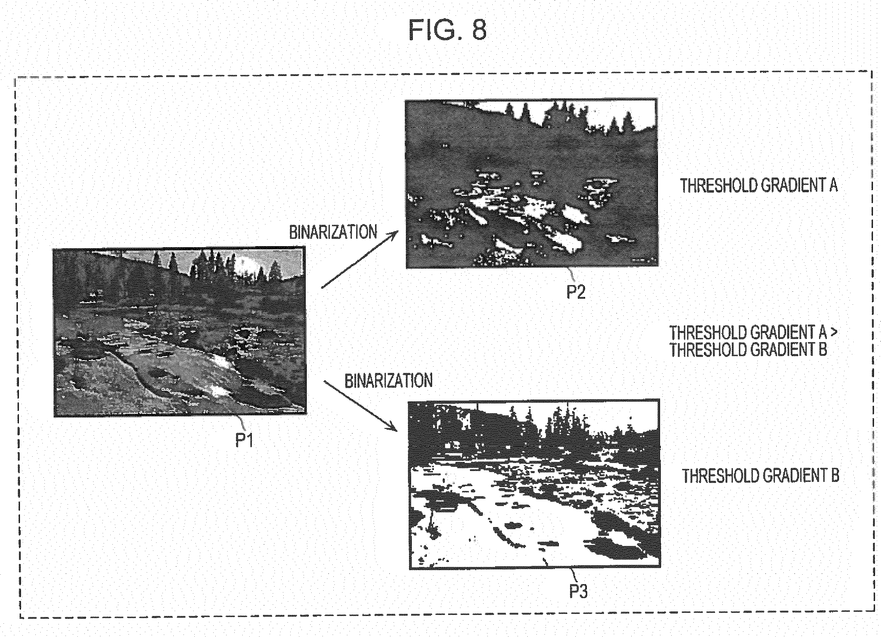

Fig. 8 is a diagram illustrating binarization of pictures indicated by picture signals.

For example, binarizing a picture P1 indicated by picture signals using a threshold value gradient A generates a picture P2 made up of bright regions and dark regions. Also, binarizing the picture P1 indicated by picture signals using a threshold value gradient B that is lower than the threshold value gradient A generates a picture P3 made up of bright regions and dark regions. Now, the bright regions of the picture P2 are narrower than the bright regions of the picture P3, since threshold value gradient A > threshold value gradient B. Visible light signals are transmitted by only the LEDs in the bright regions in each of the picture P2 and picture P3 exhibiting luminance change in accordance with the light ID, out of the multiple LEDs included in the LED panel 130.

Accordingly, the light ID control unit 150 can change the magnitude of the region of the LED panel 130 transmitting visible light signals, by adjusting the threshold value gradient. For example, visible light signals can be transmitted from relatively dark pixels (LEDs) as well by lowering the threshold value gradient.

Note that the LED driver circuit 140 according to the present embodiment does not have to be a current control circuit that controls current values. This may be a voltage control circuit that controls voltage values, for example.

Although the picture display device 100 has been described as switching between High and Low of control signals in accordance with a light ID in the above example, drive signals may be switched between ON and OFF in accordance with the light ID.

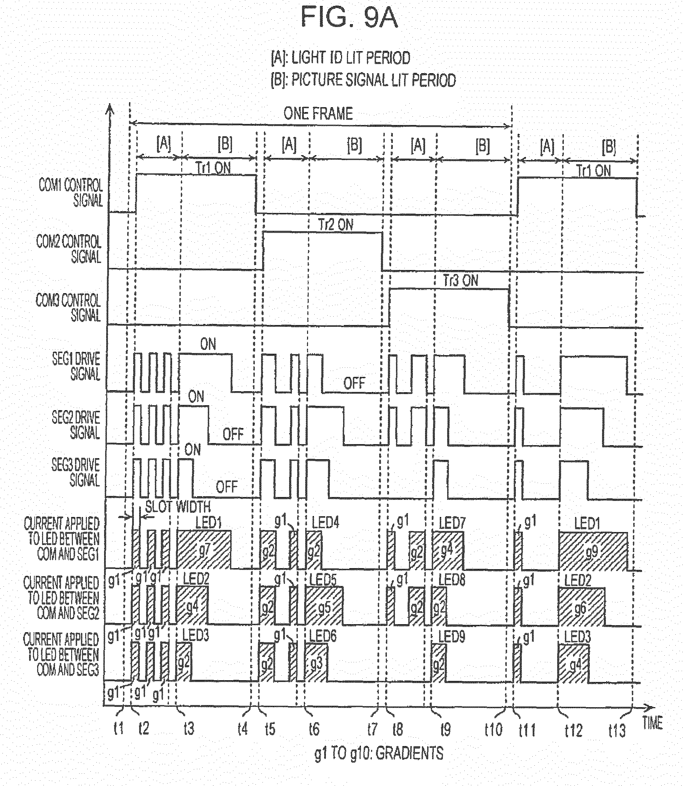

Fig. 9A is a diagram illustrating another example of timings of the signals and the currents used in the picture display device 100 according to the present embodiment. In this example, the light ID control unit 150 outputs the light ID and correction signals to the LED driver circuit 140.

During the light ID lit period [A] (point-in-time t2 through t3), the time-division switching control unit 110 switches, out of the COM1 control signal through COM3 control signal, only the COM1 control signal, to High. As a result, only the transistor Tr1 in the switch circuit 120 is switched on during the light ID lit period [A] (point-in-time t2 through t3).

At this time, during the light ID lit period [A] (point-in-time t2 through t3), the LED driver circuit 140 switches ON and OFF the SEG1 drive signal, SEG2 drive signal, and SEG3 drive signal, for controlling the LEDs 1 through 3, in accordance with the light ID. Accordingly, during a period where the COM1 control signal is High and the SEG1 drive signal is ON, current flows to the LED 1 (between COM1 and SEG1), and the LED 1 is lit. In the same way, during a period where the COM1 control signal is High and the SEG2 drive signal is ON, current flows to the LED 2 (between COM1 and SEG2), and the LED 2 is lit. In the same way, during a period where the COM1 control signal is High and the SEG3 drive signal is ON, current flows to the LED 3 (between COM1 and SEG3), and the LED 3 is lit. Thus, during the light ID lit period [A] (point-in-time t2 through t3) the LEDs 1 through 3 transmit visible light signals by luminance change in accordance with the light ID.

Further, during the picture signal lit period [B] (point-in-time t3 through t4) following the light ID lit period [A] (point-in-time t2 through t3), the time-division switching control unit 110 switches, out of the COM1 control signal through COM3 control signal, only the COM1 control signal, to High. As a result, the transistor Tr1 turns on. At this time, the LED driver circuit 140 turns ON the SEG1 drive signal, SEG2 drive signal, and SEG3 drive signal, for controlling the LEDs 1 through 3, in accordance with picture signals.

Now, the light ID control unit 150 according to the present embodiment generates correction signals for lowering the gradient of luminance of the picture signals during the picture signal lit period [B] (point-in-time t3 through t4), in the same way as the example illustrated in Fig. 7A. That is to say, the light ID control unit 150 generates correction signals for lowering the gradient of luminance of the picture signals by an amount corresponding to a gradient of luminance representing the light ID (first luminance) during the immediately-previous light ID lit period [A] (point-in-time t2 through t3). The light ID control unit 150 then outputs the correction signals to the LED driver circuit 140. The LED driver circuit 140 controls the luminance of the LEDs by PWM, using drive signals. Accordingly, in the picture signal lit period [B] (point-in-time t3 through t4), the LED driver circuit 140 reduces the period of the drive signals being ON in accordance with the picture signals, according to the correction signals.

Accordingly, during a period where the COM1 control signal is High and the SEG1 drive signal is ON, current flows to the LED 1 (between COM1 and SEG1), and the LED 1 is lit at luminance of gradient 7 (g7). In the same way, during a period where the COM1 control signal is High and the SEG2 drive signal is ON, current flows to the LED 2 (between COM1 and SEG2), and the LED 2 is lit at luminance of gradient 4 (g4). In the same way, during a period where the COM1 control signal is High and the SEG3 drive signal is ON, current flows to the LED 3 (between COM1 and SEG3), and the LED 3 is lit at luminance of gradient 2 (g2).

The picture display device 100 also performs processing the same as described above in the light ID lit period [A] (point-in-time t5 through t6) and picture signal lit period [B] (point-in-time t6 through t7) after this picture signal lit period [B] (point-in-time t3 through t4) has elapsed. The picture display device 100 further performs processing the same as described above in the light ID lit period [A] (point-in-time t8 through t9) and picture signal lit period [B] (point-in-time t9 through t10) after the picture signal lit period [B] (point-in-time t6 through t7) has elapsed.

However, in the present embodiment, in a case where the picture gradient of an LED is lower than the correction gradient, the LED driver circuit 140 does not turn ON the drive signal corresponding to that LED, but rather OFF during the light ID lit period, in the same way as in the example illustrated in Fig. 7A. That is to say, the LED driver circuit 140 does not cause that LED to perform luminance change to transmit visible light signals. Further, the LED driver circuit 140 does not perform correction in accordance with correction signals regarding the picture gradient of that LED during the picture signal lit period. That is to say, the LED driver circuit 140 does not perform correction in accordance with correction signals regarding the period of the drive singals corresponding to that LED being ON in accordance with picture signals.

Specifically, during the light ID lit period [A] (point-in-time t8 through t9), the time-division switching control unit 110 switches, out of the COM1 control signal through COM3 control signal, only the COM3 control signal, to High. As a result, only the transistor Tr3 in the switch circuit 120 is switched on during the light ID lit period [A] (point-in-time t8 through t9).

At this time, during the light ID lit period [A] (point-in-time t8 through t9), the LED driver circuit 140 turns the SEG1 drive signal and SEG2 drive signal to control the LEDs 7 and 8 ON and OFF in accordance with the light ID. On the other hand, the LED driver circuit 140 turns OFF the SEG3 drive signal that controls the LED 9. The picture gradient (e.g., second gradient) of the LED 9 is lower than the correction gradient (e.g., third gradient), so the LED driver circuit 140 turns OFF the SEG3 drive signal that controls the LED 9, as described above.

Accordingly, during a period where the COM3 control signal is High and the SEG1 drive signal is ON, current flows to the LED 7 (between COM3 and SEG1), and the LED 7 is lit. In the same way, during a period where the COM3 control signal is High and the SEG2 drive signal is ON, current flows to the LED 8 (between COM3 and SEG2), and the LED 8 is lit. Thus, during the light ID lit period [A] (point-in-time t8 through t9), only the LEDs 7 and 8, out of the LEDs 7 through 9, transmit visible light signals by luminance change in accordance with the light ID.

Further, during the picture signal lit period [B] (point-in-time t9 through t10) following the light ID lit period [A] (point-in-time t8 through t9), the time-division switching control unit 110 switches, out of the COM1 control signal through COM3 control signal, only the COM3 control signal, to High. As a result, the transistor Tr3 continues to be on. At this time, the LED driver circuit 140 turns ON the SEG1 drive signal, SEG2 drive signal, and SEG3 drive signal, for controlling the LEDs 7 through 9, in accordance with picture signals.

Now, the light ID control unit 150 according to the present embodiment generates correction signals for lowering the gradient of luminance of the picture signals, by a gradient of luminance representing the light ID in the immediately-prior light ID lit period [A] (point-in-time t8 through t9). The light ID control unit 150 then outputs the correction signals to the LED driver circuit 140. The LED driver circuit 140 shortens the period of the drive signals being ON in accordance with the picture signals in the picture signal lit period [B] (point-in-time t9 through t10), according to the correction signals.

For example, in a case where the LEDs 7 and 8 are lit by a period equivalent to the luminance of gradient 3 in accordance with the light ID in light ID lit period [A] (point-in-time t8 through t9), the light ID control unit 150 outputs correction signals indicating correction gradient 3 to the LED driver circuit 140. If the picture gradient of the LED 7 is 7 in the picture signal lit period [B] (point-in-time t9 through t10), the LED driver circuit 140 subtracts the correction gradient 3 from the picture gradient 7. As a result, the LED driver circuit 140 turns the SEG1 drive signal ON by a period corresponding to gradient 4 (picture gradient 7 minus correction gradient 3) during the picture signal lit period [B] (point-in-time t9 through t10). In the same way, if the picture gradient of the LED 8 is 5 in the picture signal lit period [B] (point-in-time t9 through t10), the LED driver circuit 140 subtracts the correction gradient 3 from the picture gradient 5. As a result, the LED driver circuit 140 turns the SEG2 drive signal ON by a period corresponding to gradient 2 (picture gradient 5 minus correction gradient 3) during the picture signal lit period [B] (point-in-time t9 through t10).

On the other hand, if the picture gradient of the LED 9 is 2 in the picture signal lit period [B] (point-in-time t9 through t10), the LED driver circuit 140 judges that the picture gradient 2 is lower than the correction gradient 3. At this time, the LED driver circuit 140 turns the SEG3 drive signal ON by a period corresponding to the picture gradient 2 of the LED 9 in the picture signal lit period [B] (point-in-time t9 through t10). That is to say, the LED driver circuit 140 does not correct, in accordance with the correction signal, the period for turning the drive signal ON in accordance with the picture signal, in the picture signal lit period.

Accordingly, during a period where the COM3 control signal is High and the SEG1 drive signal is ON, current flows to the LED 7 (between COM3 and SEG1), and the LED 7 is lit at luminance of gradient 4 (g4). In the same way, during a period where the COM3 control signal is High and the SEG2 drive signal is ON, current flows to the LED 8 (between COM3 and SEG2), and the LED 8 is lit at luminance of gradient 2 (g2). In the same way, during a period where the COM3 control signal is High and the SEG3 drive signal is ON, current flows to the LED 9 (between COM3 and SEG3), and the LED 9 is lit at luminance of gradient 2 (g2).

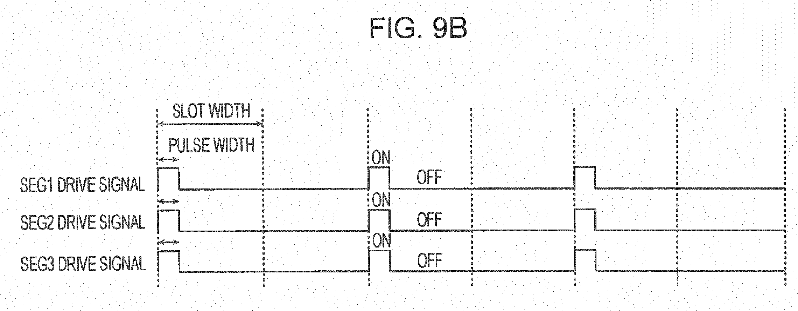

Fig. 9B is a diagram illustrating the relation between slot width and pulse width, applied to the example illustrated in Fig. 9A.

In a case of the picture display device 100 controlling the signals and currents in accordance with the timings illustrated in Fig. 9A as well, the LED driver circuit 140 may light the LEDs in the same way as the example illustrated in Fig. 5. That is to say, the LED driver circuit 140 lights LEDs corresponding to the SEG1 drive signal by switching the SEG1 drive signal between ON and OFF, as illustrated in Fig. 9B. At this time, the LED driver circuit 140 lights the LEDs for the period of that slot by causing the LEDs to repeatedly emit pulse light of a time width shorter than the slot. This enables the duty ratio to be optionally set for light ID in 4PPM. Note that the LED driver circuit 140 performs switching in the same way as the SEG1 drive signal regarding the SEG2 drive signal and SEG3 drive signal as well.

Note that the LED driver circuit 140 according to the present embodiment does not have to be a current control circuit that controls current values. This may be a voltage control circuit that controls voltage values, for example.

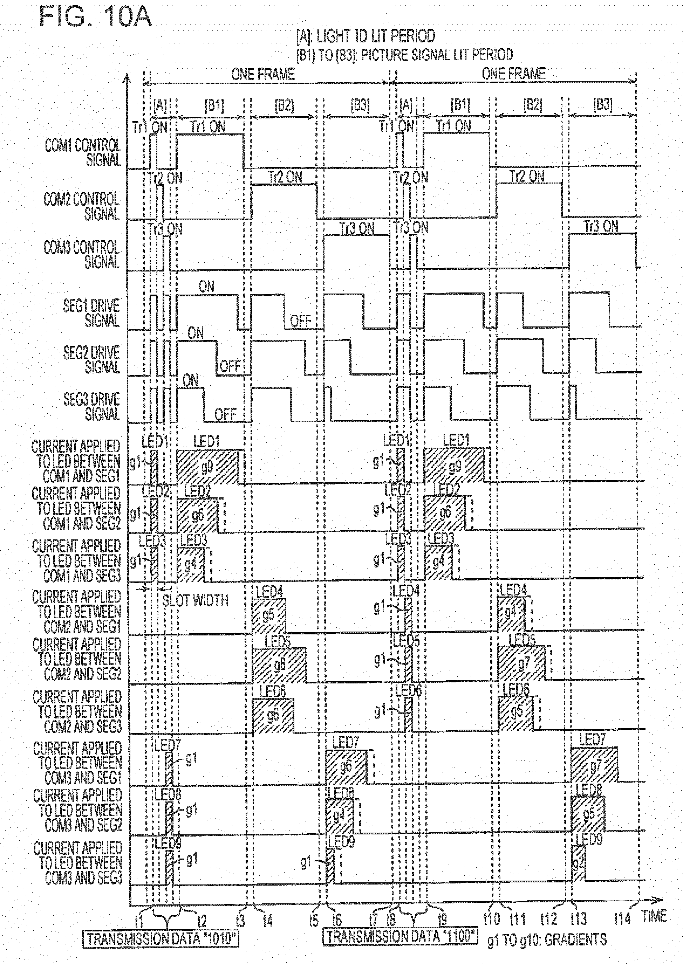

Fig. 10A is a diagram illustrating another example of timings of the signals and the currents used in the picture display device 100 according to the present embodiment. In this example, the light ID control unit 150 outputs the light ID and correction signals to the LED driver circuit 140. Also, in this example, the frame display period is made up of a light ID lit period [A] and three subsequent picture signal lit periods [B1] through [B3]. One frame is expressed by lighting of the LEDs 1 through 9 during these periods.

During the light ID lit period [A] (point-in-time t1 through t2), the time-division switching control unit 110 switches, out of the COM1 control signal through COM3 control signal, only the COM1 control signal, to High in the first slot out of the four slots included in that period. The time-division switching control unit 110 then switches only the COM2 control signal out of the COM1 control signal through COM3 control signal to High in the second slot. The time-division switching control unit 110 further switches only the COM3 control signal out of the COM1 control signal through COM3 control signal to High in the third slot.

As a result, the transistors in the switch circuit 120 are switched on in the order of the transistor Tr1, transistor Tr2, and transistor Tr3, in respective slots, during the light ID lit period [A] (point-in-time t1 through t2). Note that the slot width in this example is narrower than the slot width illustrated in Fig. 7A and Fig. 9A (e.g., 104 µs), and is 5 µs for example.

At this time, during the light ID lit period [A] (point-in-time t1 through t2), the LED driver circuit 140 switches ON and OFF the SEG1 drive signal, SEG2 drive signal, and SEG3 drive signal, that control the LEDs 1 through 9, in accordance with the light ID. Accordingly, during slots where the control signals are High and the drive signals are ON, current flows to the LEDs corresponding to the control signals and drive signals in the LED panel 130, and the LEDs are lit. For example, the LEDs 1 through 3 are lit in the first slot in light ID lit period [A] (point-in-time t1 through t2), and the LEDs 7 through 9 are lit in the third slot. Accordingly, the LEDs 1 through 9 exhibit luminance change in accordance with the light ID (e.g., "1010") in the light ID lit period [A] (point-in-time t1 through t2), thereby transmitting visible light signals.

In this way, during the light ID lit period [A] illustrated in Fig. 10A, the first line made up of LEDs 1 through 3, the second line made up of LEDs 4 through 6, and the third line made up of LEDs 7 through 9, are respectively lit or go off in slots correlated with the lines. Accordingly, a light ID (visible light signals) indicating High or Low is transmitted in each of multiple slots.

Further, during the picture signal lit period [B1] (point-in-time t2 through t3) following the light ID lit period [A] (point-in-time t1 through t2), the time-division switching control unit 110 switches, out of the COM1 control signal through COM3 control signal, only the COM1 control signal, to High. As a result, the transistor Tr1 turns on. At this time, the LED driver circuit 140 turns ON the SEG1 drive signal, SEG2 drive signal, and SEG3 drive signal, for controlling the LEDs 1 through 3, in accordance with picture signals.

Now, the light ID control unit 150 according to the present embodiment generates correction signals for lowering the gradient of luminance of the picture signals during the picture signal lit period [B1] (point-in-time t1 through t2), in the same way as the example illustrated in Fig. 7A. That is to say, the light ID control unit 150 generates correction signals for lowering the gradient of luminance of the picture signals by an amount corresponding to a gradient of luminance representing the light ID (first gradient) during the immediately-previous light ID lit period [A] (point-in-time t1 through t2). The light ID control unit 150 then outputs the correction signals to the LED driver circuit 140. The LED driver circuit 140 controls the luminance of the LEDs by PWM, using drive signals. Accordingly, in the picture signal lit period [B1] (point-in-time t2 through t3), the LED driver circuit 140 reduces the period of the drive signals being ON in accordance with the picture signals, according to the correction signals.

For example, the LEDs 1 through 3 each are lit for a slot corresponding to luminance of gradient 1 in light ID lit period [A] (point-in-time t1 through t2), so the light ID control unit 150 outputs correction signals indicating correction gradient 1 to the LED driver circuit 140. If the picture gradient of the LED 1 is 10 in the picture signal lit period [B1] (point-in-time t2 through t3), the LED driver circuit 140 subtracts the correction gradient 1 from the picture gradient 10. As a result, the LED driver circuit 140 turns the SEG1 drive signal ON by a period corresponding to gradient 9 (correction gradient 10 minus correction gradient 1) during the picture signal lit period [B1] (point-in-time t2 through t3). In the same way, if the picture gradient of the LED 2 is 7 in the picture signal lit period [B1] (point-in-time t2 through t3), the LED driver circuit 140 subtracts the correction gradient 1 from the picture gradient 7. As a result, the LED driver circuit 140 turns the SEG2 drive signal ON by a period corresponding to gradient 6 (picture gradient 7 minus correction gradient 1) during the picture signal lit period [B1] (point-in-time t2 through t3). In the same way, if the picture gradient of the LED 3 is 5 in the picture signal lit period [B1] (point-in-time t2 through t3), the LED driver circuit 140 subtracts the correction gradient 1 from the picture gradient 5. As a result, the LED driver circuit 140 turns the SEG3 drive signal ON by a period corresponding to gradient 4 (picture gradient 5 minus correction gradient 1) during the picture signal lit period [B1] (point-in-time t2 through t3).

Accordingly, during a period where the COM1 control signal is High and the SEG1 drive signal is ON, current flows to the LED 1 (between COM1 and SEG1), and the LED 1 is lit at luminance of gradient 9 (g9). In the same way, during a period where the COM1 control signal is High and the SEG2 drive signal is ON, current flows to the LED 2 (between COM1 and SEG2), and the LED 2 is lit at luminance of gradient 6 (g6). In the same way, during a period where the COM1 control signal is High and the SEG3 drive signal is ON, current flows to the LED 3 (between COM1 and SEG3), and the LED 3 is lit at luminance of gradient 4 (g4).

Further, during the picture signal lit period [B2] (point-in-time t4 through t5) following the light picture signal lit period [B1] (point-in-time t2 through t3), the time-division switching control unit 110 switches, out of the COM1 control signal through COM3 control signal, only the COM2 control signal, to High. As a result, the transistor Tr2 turns on. At this time, the LED driver circuit 140 turns ON the SEG1 drive signal, SEG2 drive signal, and SEG3 drive signal, for controlling the LEDs 4 through 6, in accordance with picture signals.

Now, the LEDs 4 through 6 are not each lit during the light ID lit period [A] (point-in-time t1 through t2). As a result, the light ID control unit 150 does not output correction signals indicating gradient 1 to the LED driver circuit 140. Accordingly, if the picture gradient of the LED 4 is 5 in the picture signal lit period [B2] (point-in-time t4 through t5), the LED driver circuit 140 turns the SEG1 drive signal on for a period corresponding to picture gradient 5. In the same way, if the picture gradient of the LED 5 is 8 in the picture signal lit period [B2] (point-in-time t4 through t5), the LED driver circuit 140 turns the SEG2 drive signal on for a period corresponding to picture gradient 8. In the same way, if the picture gradient of the LED 9 is 6 in the picture signal lit period [B2] (point-in-time t4 through t5), the LED driver circuit 140 turns the SEG3 drive signal on for a period corresponding to picture gradient 6.

Accordingly, during a period where the COM2 control signal is High and the SEG1 drive signal is ON, current flows to the LED 4 (between COM2 and SEG1), and the LED 4 is lit at luminance of gradient 5 (g5). In the same way, during a period where the COM2 control signal is High and the SEG2 drive signal is ON, current flows to the LED 5 (between COM2 and SEG2), and the LED 5 is lit at luminance of gradient 8 (g8). In the same way, during a period where the COM2 control signal is High and the SEG3 drive signal is ON, current flows to the LED 6 (between COM2 and SEG3), and the LED 6 is lit at luminance of gradient 6 (g6).

Further, during the picture signal lit period [B3] (point-in-time t6 through t7) following the picture signal lit period [B2] (point-in-time t4 through t5) having elapsed, the time-division switching control unit 110 switches, out of the COM1 control signal through COM3 control signal, only the COM3 control signal, to High. As a result, the transistor Tr3 turns on. At this time, the LED driver circuit 140 turns ON the SEG1 drive signal, SEG2 drive signal, and SEG3 drive signal, for controlling the LEDs 7 through 9, in accordance with picture signals.

Now, the LEDs 7 through 9 are each lit during the light ID lit period [A] (point-in-time t1 through t2) for slots corresponding to luminance of gradient 1, so the light ID control unit 150 outputs correction signals indicating correction gradient 1 to the LED driver circuit 140. If the picture gradient of the LED 7 is 7 in the picture signal lit period [B3] (point-in-time t6 through t7), the LED driver circuit 140 subtracts the correction gradient 1 from the picture gradient 7. As a result, the LED driver circuit 140 turns the SEG1 drive signal ON by a period corresponding to gradient 6 (picture gradient 7 minus correction gradient 1) during the picture signal lit period [B3] (point-in-time t6 through t7). In the same way, if the picture gradient of the LED 8 is 5 in the picture signal lit period [B3] (point-in-time t6 through t7), the LED driver circuit 140 subtracts the correction gradient 1 from the picture gradient 5. As a result, the LED driver circuit 140 turns the SEG2 drive signal ON by a period corresponding to gradient 4 (picture gradient 5 minus correction gradient 1) during the picture signal lit period [B3] (point-in-time t6 through t7). In the same way, if the picture gradient of the LED 9 is 2 in the picture signal lit period [B3] (point-in-time t6 through t7), the LED driver circuit 140 subtracts the correction gradient 1 from the picture gradient 2. As a result, the LED driver circuit 140 turns the SEG3 drive signal ON by a period corresponding to gradient 1 (picture gradient 2 minus correction gradient 1) during the picture signal lit period [B3] (point-in-time t6 through t7).

Accordingly, during a period where the COM3 control signal is High and the SEG1 drive signal is ON, current flows to the LED 7 (between COM3 and SEG1), and the LED 7 is lit at luminance of gradient 6 (g6). In the same way, during a period where the COM3 control signal is High and the SEG2 drive signal is ON, current flows to the LED 8 (between COM3 and SEG2), and the LED 8 is lit at luminance of gradient 4 (g4). In the same way, during a period where the COM3 control signal is High and the SEG3 drive signal is ON, current flows to the LED 9 (between COM3 and SEG3), and the LED 9 is lit at luminance of gradient 1 (g1).

Thus, the light ID lit period [A] in one frame is short, and the period that one LED actually is lit is only one slot worth in the light ID lit period [A], in the example illustrated in Fig. 10A. The slot width is 5 µs, for example. Accordingly, even if the LED panel 130 is exhibiting luminance change in accordance with the light ID to transmit visible light signals, flickering due to the luminance change can be suppressed, and further, disturbance in the picture can also be suppressed.

Although the slot width has been described as being 5 µs which is the same as the pulse width in the example illustrated in Fig. 10A, the slot width may be longer than the pulse width, as in the example illustrated in Fig. 5.

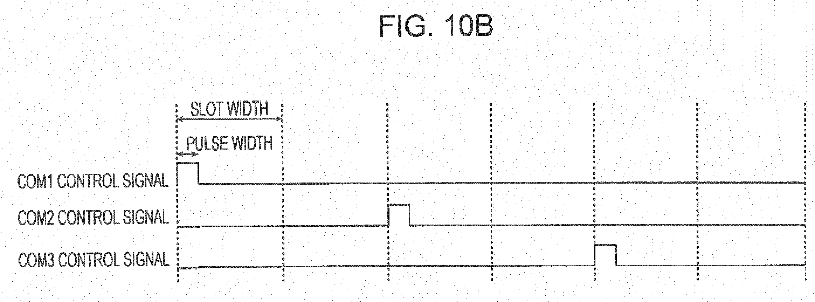

Fig. 10B is a diagram illustrating the relation between slot width and pulse width, regarding control signals applied to the example illustrated in Fig. 10A.

In a case of the picture display device 100 controlling the signals and currents in accordance with the timings illustrated in Fig. 10A as well, the time-division switching control unit 110 may light the LEDs in the same way as the example illustrated in Fig. 5. That is to say, the time-division switching control unit 110 lights LEDs corresponding to the COM1 control signal by switching the COM1 control signal between High and Low, as illustrated in Fig. 10B. At this time, the time-division switching control unit 110 lights the LEDs for the period of that slot by causing the LEDs to repeatedly emit pulse light of a time width shorter than the slot. This enables the duty ratio to be optionally set for light ID in 4PPM. Note that the time-division switching control unit 110 performs switching in the same way as the COM1 control signal regarding the COM2 control signal and COM3 control signal as well.

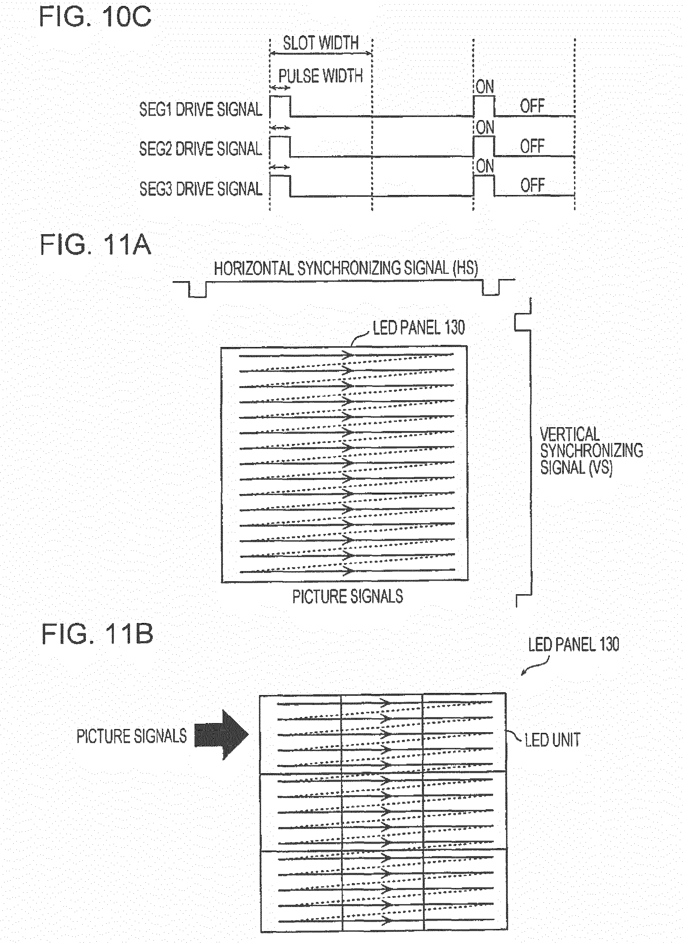

Fig. 10C is a diagram illustrating the relation between slot width and pulse width, regarding drive signals applied to the example illustrated in Fig. 10A.

In a case of the picture display device 100 controlling the signals and currents in accordance with the timings illustrated in Fig. 10A as well, the LED driver circuit 140 may light the LEDs in the same way as the example illustrated in Fig. 5. That is to say, the LED driver circuit 140 lights LEDs corresponding to the SEG1 drive signal by switching the SEG1 drive signal between ON and OFF, as illustrated in Fig. 10C. At this time, the LED driver circuit 140 lights the LEDs for the period of that slot by causing the LEDs to repeatedly emit pulse light of a time width shorter than the slot. This enables the duty ratio to be optionally set for light ID in 4PPM. Note that the LED driver circuit 140 performs switching in the same way as the SEG1 drive signal regarding the SEG2 drive signal and SEG3 drive signal as well.

Also, the time-division switching control unit 110 and LED driver circuit 140 may each control the signals and the currents in accordance with the timings illustrated in Fig. 10A, while performing the control illustrated in Fig. 10B and Fig. 10C at the same time.

An example of an LED driver circuit 140 that can be used to control drive signals as in the example illustrated in Fig. 10A is a TLC5958 manufactured by Texas Instruments of the USA.

Further, the LED driver circuit 140 according to the present embodiment does not have to be a current control circuit that controls current values. This may be a voltage control circuit that controls voltage values, for example.

Fig. 11A is a diagram illustrating the relation between the LED panel and picture signals.

The LED panel 130 of the picture display device 100 has nine LEDs, to simplify description, but may have nine or more LEDs. Picture signals are output in raster scan order to the LEDs of the LED panel 130, as illustrated in Fig. 11A.

Now, in a case where the LED panel 130 is a large-size panel including a greater number of LEDs, it may be configured of multiple LED units.

Fig. 11B is a diagram illustrating an example of the LED panel 130 configured of multiple LED units.

The LED panel 130 is configured of three rows by three columns of LED units, for example. An LED unit is a unit where multiple LEDs have been arrayed in the horizontal direction and vertical direction. In such an LED panel 130, each LED unit, upon obtaining picture signals corresponding that LED unit, starts display of a picture corresponding to the picture signals at the point of obtaining. Accordingly, in a case where picture signals are simply output to the LEDs of the LED panel 130 in raster scan order, the display timing of the picture will differ among the LED units. Particularly, the picture display timing will be greatly different between the LED unit at the upper left edge of the LED panel 130 and the LED unit at the lower right edge. The picture display device 100 according to the present embodiment may have picture memory to prevent such a display timing lag.

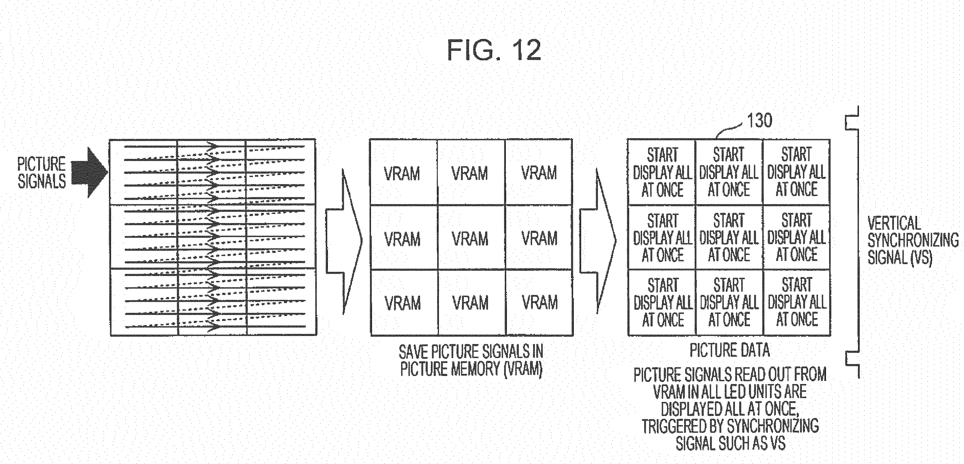

Fig. 12 is a diagram illustrating an example of a picture display method of the LED panel.

The picture display device 100 according to the present embodiment has picture memory such as VRAM (Video Random Access Memory) or the like. The picture display device 100 saves the picture signals input to the LED panel 130 in the VRAM, in order to match the display timing of the picture among the LED units. That is to say, the picture signals corresponding to each of the LED units is temporarily saved in the respective VRAMs. The picture display device 100 then causes all LED units in the LED panel 130 to start display of the picture based on the picture signals for the respective LED units saved in VRAM all at once, at a predetermined timing. The aforementioned predetermined timing is, for example, a timing where a synchronizing signal such as a vertical synchronizing signal (VS) or the like has been obtained.

Accordingly, the display timing of a picture can be suppressed from being different among LED units in the LED panel 130.

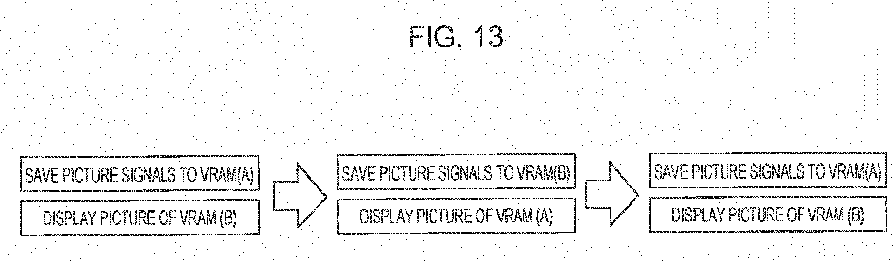

Fig. 13 is a diagram illustrating another example of a picture display method of the LED panel.

The picture display device 100 may have two screens worth of picture memory such as VRAM. That is to say, the picture display device 100 has two VRAMs (VRAM (A) and VRAM (B)) to be able to store two pictures to be displayed on the LED panel 130. The picture display device 100 performs saving of picture signals to one of the VRAMs, and picture display based on picture signals saved in the other VRAM, in parallel.

For example, the picture display device 100 performs saving of picture signals to the VRAM (A) and displaying of a picture in the VRAM (B) in parallel, and next performs saving of picture signals to the VRAM (B) and displaying of a picture in the VRAM (A) in parallel, as illustrated in Fig. 13. Further, the picture display device 100 performs saving of picture signals to the VRAM (A) and displaying of a picture in the VRAM (B) in parallel.

In this way, the delay of picture display can be suppressed to within one frame worth, by performing saving and display in parallel using the respective VRAMs, and switching the VRAMs used for saving and displaying.

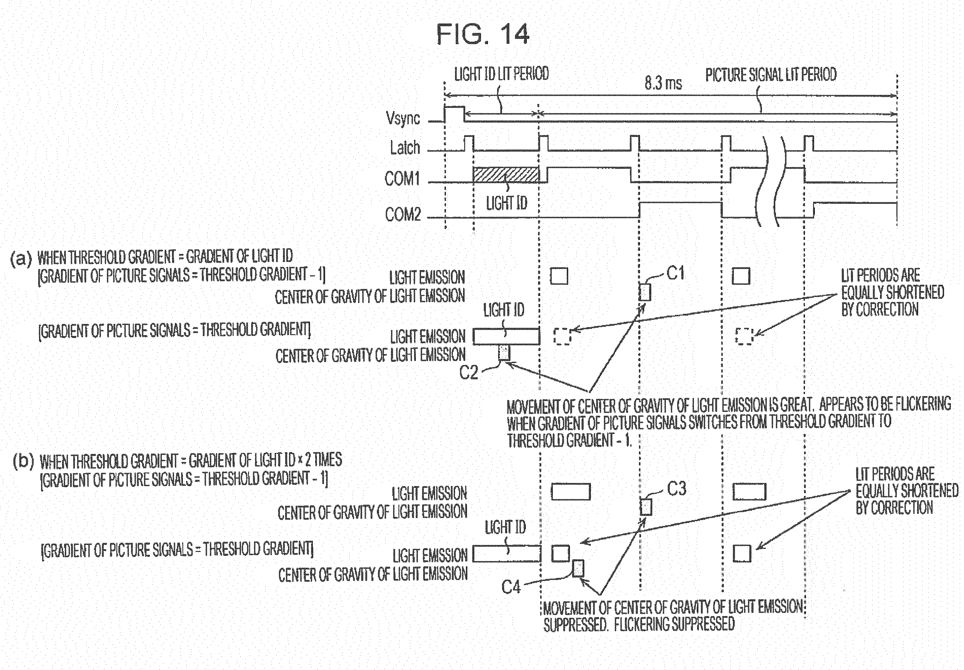

Fig. 14 is a diagram for describing an example of flickering suppression.

For example, the picture display device 100 causes the LED panel 130 to execute luminance change according to the light ID during the light ID lit period, by turning the COM1 control signal to High, in the same way as the example illustrated in Fig. 4. At this time, the picture display device 100 lowers the luminance of the picture signals by a gradient of luminance representing the light ID, in the picture signal lit period following the light ID lit period thereof. Note that the gradient of luminance representing the light ID (first gradient) is the same as the above-described correction gradient, and hereinafter will also be referred to as light ID gradient. The gradient of luminance of the picture signals is the above-described picture gradient, and will also be referred to as picture signals gradient.

That is to say, when the COM1 control signal is High in the picture signal lit period thereof, the picture display device 100 lowers the picture gradient. If there are multiple times where the COM1 control signal becomes High in that picture signal lit period, the picture display device 100 lowers the picture gradient at these points (High points). Thus, the picture gradient is corrected. Note that a point where a control signal such as the COM1 control signal or COM2 control signal becomes High is also referred to as a loop.

Now, as illustrated in (a) in Fig. 14, flickering will occur at the LED panel 130 in a case where the threshold value used for determination of whether or not to cause an LED to perform luminance change in accordance with the light ID (threshold value gradient) and the light ID gradient are the same, i.e., in a case where threshold value gradient = light ID gradient.

For example, in a case where the picture gradient is lower than the threshold value gradient, specifically in a case of "threshold value gradient minus 1", luminance change in accordance with the light ID is not performed during the light ID lit period. Further, in the picture signal lit period, LEDs of the LED panel 130 corresponding to the COM1 control signal are lit at the gradient of luminance in accordance with the picture signals thereof at the point that the COM1 control signal becomes High. Now, in a case where there are two points (loops) where the COM1 control signal becomes High that are away from each other, the LED is lit at these points, so a center of gravity of light emission C1 will be situated around midway between these points.

On the other hand, in a case where the picture gradient and the threshold value gradient are equal, luminance change in accordance with the light ID is performed during the light ID lit period. However, in the picture signal lit period, the LEDs of the LED panel 130 corresponding to the COM1 control signal are not lit even at a point where the COM1 control signal is high, due to the correction on the picture signals. Accordingly, in such a case, a center of gravity of light emission C2 will be situated around midway of the period in which luminance change is performed in accordance with the light ID.

Accordingly, in a case where threshold value gradient = light ID gradient, the center of gravity of light emission will greatly shift depending on whether the picture gradient is the threshold value gradient or is "threshold value gradient minus 1". The LED panel 130 appears to flicker due to the shifting or moving of the center of gravity of light emission.

Accordingly, the picture display device 100 according to the present embodiment does not set the threshold value gradient to be the same as the light ID gradient, but sets it higher than the gradient of luminance of the light ID, e.g., to 2 times (or 1.5 times) the light ID gradient, as illustrated in (b) in Fig. 14. That is to say, in the present embodiment, the threshold value gradient is higher than the first gradient. Specifically, the threshold value gradient is generally 1.5 times the first gradient or higher.

For example, in a case where the picture gradient is lower than the threshold value gradient by just one gradient, specifically in a case of "threshold value gradient minus 1", luminance change in accordance with the light ID is not performed in the light ID lit period. Further, the LEDs of the LED panel 130 corresponding to the COM1 control signal are lit at the gradient of luminance in accordance with the picture signals thereof at the point that the COM1 control signal becomes High. Now, in a case where there are two points where the COM1 control signal becomes high, that are away from each other, the LEDs are lit at those points, so a center of gravity of light emission C3 will be situated around midway between these points.

On the other hand, in a case where the picture gradient and threshold value gradient are equal, luminance change in accordance with the light ID is performed in the light ID lit period. The LEDs of the LED panel 130 corresponding to the COM1 control signal are lit at the two points where the COM1 control signal becomes High during the picture signal lit period. The periods of lighting at these points are equally shortened, for example, by the above-described correspond on the picture signals. Accordingly, the LEDs are lit not only lit during the light ID lit period but also in the picture signal lit period, so a center of gravity of light emission C4 can be moved toward the picture signal lit period side as compared with the case of (a) in Fig. 14.

Accordingly, the threshold value gradient is higher than the light ID gradient, so a situation where the center of gravity of light emission greatly shifts depending on whether the picture gradient is the threshold value gradient or is "threshold value gradient minus 1" can be suppressed. Accordingly, flickering when the picture gradually changes with the picture gradient straddling the threshold value gradient can be suppressed.

Also, in a case where an LED is lit at multiple loops (points) during the picture signal lit period (second period), the picture gradient (second gradient) is corrected at each of the multiple loops. During the picture signal lit period, the LED is lit at the corrected picture gradient (second gradient) at each of the multiple loops (points). Accordingly, the width of correction of the second gradient can be reduced at each of the multiple loops, and influence on picture display due to the correction can be suppressed.

Further, the second gradient is corrected at each of the multiple loops by subtracting the same gradient from the second gradient at each of the multiple loops (points) in the present embodiment. Accordingly, control of correction can be simplified.

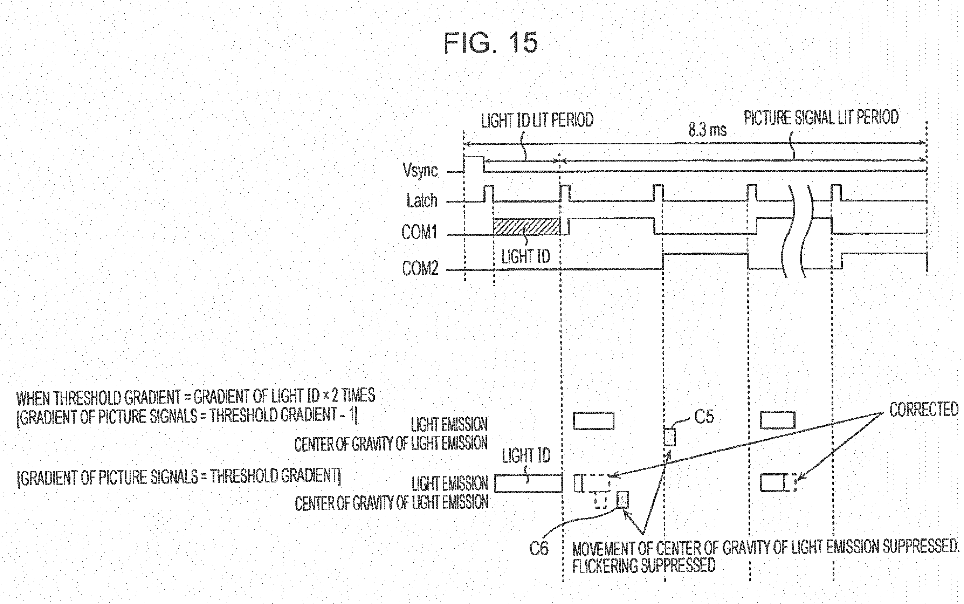

Fig. 15 is a diagram illustrating another example of flickering suppression.

The picture display device 100 according to the present embodiment may differ the width of shortening in correction of each period during which the LED is lit in accordance with picture signals as illustrated in Fig. 15, not just making the threshold value gradient to be higher than the light ID gradient (first gradient).

Specifically, as illustrated in Fig. 15, the picture display device 100 does not set the threshold value gradient to be the same as the light ID gradient, but sets it higher than the gradient of the light ID, e.g., to 2 times the light ID gradient.

In a case where the picture gradient is lower than the threshold value gradient by one gradient, specifically "threshold value gradient minus 1" when the threshold value gradient is set in such a way, luminance change is not performed in accordance with the light ID during the light ID lit period. Further, during the picture signal lit period, the LEDs of the LED panel 130 corresponding to the COM1 control signal are lit at the gradient of luminance according to the picture signals at the point that the COM1 control signal is High. Now, in a case where there are two points (loops) where the COM1 control signal becomes High that are away from each other, the LED is lit at these points, so a center of gravity of light emission C5 will be situated around midway between these points.

On the other hand, in a case where the picture gradient and the threshold value gradient are equal, luminance change in accordance with the light ID is performed during the light ID lit period. In the picture signal lit period, the LEDs of the LED panel 130 corresponding to the COM1 control signal are lit at the two points (loops) where the COM1 control signal is high. The period of lighting at these points is shortened by the above-described correction on the picture signals. At this time, the LED driver circuit 140 of the picture display device 100 makes the width of shortening the period of LED lighting to be greater at the earlier point, out of the two points where the COM1 control signal becomes High, and makes the width of shortening the period of LED lighting to be smaller at the later point. Accordingly, in the example illustrated in Fig. 15, a center of gravity of light emission C6 can be further moved to later as compared with the example illustrated in (b) in Fig. 14. That is to say, the center of gravity of light emission C6 can be brought closer to around midway between the two points where the COM1 control signal becomes High.

Thus, according to the present embodiment, n gradients (where n is an integer of 1 or greater) are subtracted from the second gradient in the first loop, out of the multiple loops (points). Further, m gradients (where m is an integer of 1 or greater but smaller than n) is subtracted from the second gradient in the second loop that is farther from the light ID lit period (first period) than the first loop, out of the multiple loops. The second gradient of each of the first and second loops is corrected by this subtraction.

Accordingly, a situation where the center of gravity of light emission shifts depending on whether the picture gradient is the threshold value gradient or is "threshold value gradient minus 1" can be suppressed even further. Accordingly, flickering when the picture gradually changes with the picture gradient straddling the threshold value gradient can be suppressed, for example.

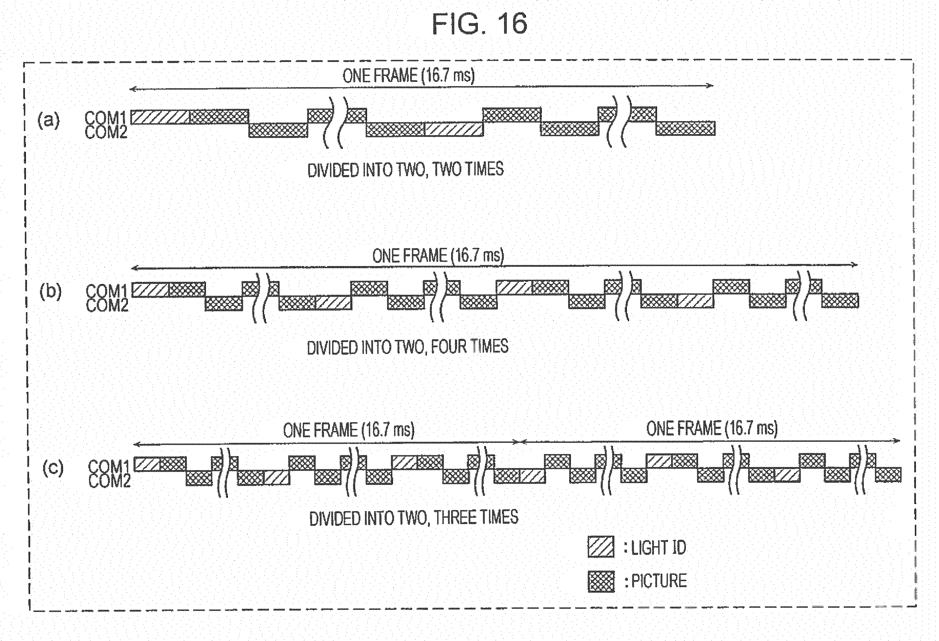

Fig. 16 is a diagram illustrating the timing of the LED panel 130 in accordance with a light ID during a 1-frame display period.

For example, the LED panel 130 is made up of multiple COM1 lines controlled by COM1 control signals, and multiple COM2 lines controlled by COM2 control signals, as illustrated in (a) in Fig. 16. The COM1 lines and COM2 lines are each made up of multiple LEDs each arrayed in the horizontal direction, and may each be odd-numbered lines or even-numbered lines.

In this case, the region of the LED panel 130 that exhibits luminance change in accordance with the light ID is divided into two. One region of the two is a region made up of multiple COM1 lines, and the other region is a region made up of multiple COM2 lines.

The multiple COM1 lines exhibit luminance change in accordance with the light ID at the front half of the 1-frame display period, while the multiple COM2 lines exhibit luminance change in accordance with the light ID at the latter half of the 1-frame display period. Thus, luminance change according to light ID, i.e., transmission of visible light signals, by the multiple COM1 lines and multiple COM2 lines, is performed twice in the 1-frame display period.

Alternatively, an arrangement may be made where the multiple COM1 lines exhibit luminance change in accordance with the light ID twice during the 1-frame display period, and the multiple COM2 lines exhibit luminance change in accordance with the light ID twice during the 1-frame display period, as illustrated in (b) in Fig. 16. That is to say, luminance change according to light ID, i.e., transmission of visible light signals, by the multiple COM1 lines and multiple COM2 lines, may be performed four times in the 1-frame display period. The interval between the timings of which transmission of visible light signals is performed these four times may be equal.

Alternatively, an arrangement may be made where the multiple COM1 lines exhibit luminance change in accordance with the light ID twice or once during the 1-frame display period, and the multiple COM2 lines exhibit luminance change in accordance with the light ID once or twice during the 1-frame display period, as illustrated in (c) in Fig. 16. That is to say, luminance change according to light ID, i.e., transmission of visible light signals, by the multiple COM1 lines and multiple COM2 lines, may be performed three times (odd number of times) in the 1-frame display period. The interval between the timings of which transmission of visible light signals is performed these three times may be equal.

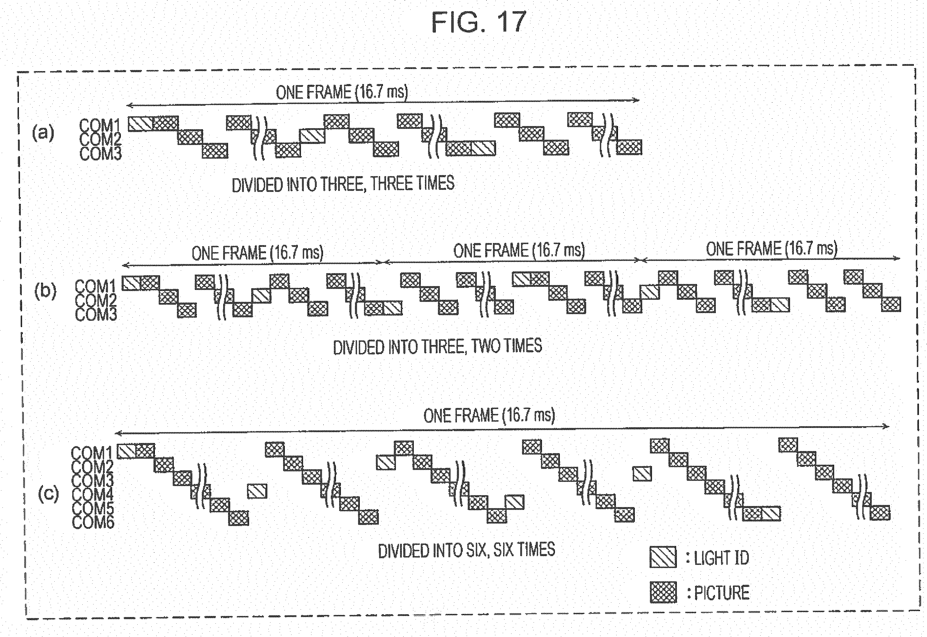

Fig. 17 is a diagram illustrating the timing of the LED panel 130 performing luminance change in accordance with a light ID during a 1-frame display period.

For example, the LED panel 130 is made up of multiple COM1 lines controlled by COM1 control signals, multiple COM2 lines controlled by COM2 control signals, and multiple COM3 lines controlled by COM3 control signals, as illustrated in (a) in Fig. 17. The COM1 lines, COM2 lines, and COM3 lines are each made up of multiple LEDs each arrayed in the horizontal direction.

In this case, the region of the LED panel 130 that exhibits luminance change in accordance with the light ID is divided into three. One region of the three is a region made up of multiple COM1 lines, another region is a region made up of multiple COM2 lines, and the remaining region is a region made up of multiple COM3 lines.

The multiple COM1 lines exhibit luminance change in accordance with the light ID one time in the 1-frame display period, and the multiple COM2 lines exhibit luminance change in accordance with the light ID one time in the 1-frame display period. The multiple COM3 lines also exhibit luminance change in accordance with the light ID one time in the 1-frame display period. Thus, luminance change according to light ID, i.e., transmission of visible light signals, by the multiple COM1 lines, multiple COM2 lines, and multiple COM3 lines is performed three times in the 1-frame display period. The interval between the timings of which transmission of visible light signals is performed these three times may be equal.

Alternatively, an arrangement may be made where the multiple COM1 lines exhibit luminance change in accordance with the light ID zero times or one time during the 1-frame display period, and the multiple COM2 lines exhibit luminance change in accordance with the light ID zero times or one time during the 1-frame display period, as illustrated in (b) in Fig. 17. The multiple COM3 lines may exhibit luminance change in accordance with the light ID zero times or one time during the 1-frame display period. That is to say, luminance change according to light ID, i.e., transmission of visible light signals, by the multiple COM1 lines, multiple COM2 lines, and multiple COM3 lines, may be performed two times (even number of times) in the 1-frame display period.

An arrangement may be made, as illustrated in (c) in Fig. 17, where the LED panel 130 has multiple COM4 lines, multiple COM5 lines, and multiple COM6 lines, not just the multiple COM1 lines, multiple COM2 lines, and multiple COM3 lines. The COM4 lines, COM5 lines, and COM6 lines are each made up of multiple LEDs arrayed in the horizontal direction, and are controlled by a COM4 control signal, COM5 control signal, and COM6 control signal, which are control signals the same as the COM1 control signal and the like.

In this case, the region of the LED panel 130 that exhibits luminance change in accordance with the light ID is divided into six. The six regions are a region made up of multiple COM1 lines, a region made up of multiple COM2 lines, a region made up of multiple COM3 lines, a region made up of multiple COM4 lines, a region made up of multiple COM5 lines, a region made up of multiple COM6 lines.

The multiple COM1 lines may exhibit luminance change in accordance with the light ID one time in the 1-frame display period, and the multiple COM2 lines exhibit luminance change in accordance with the light ID one time in the 1-frame display period. The multiple COM3 lines, the multiple COM4 lines, the multiple COM5 lines, and the multiple COM6 lines, also may exhibit luminance change in accordance with the light ID one time in the 1-frame display period, as described above. Thus, luminance change according to light ID, i.e., transmission of visible light signals, by the multiple COM1 lines through multiple COM6 lines, may be performed six times in the 1-frame display period. The interval between the timings of which transmission of visible light signals is performed these six times may be equal.

The division patterns of regions of the LED panel 130 and the number of times of transmission of visible light signals illustrated in Fig. 16 and Fig. 17 are only an example of the present embodiment, and may be any sort of division pattern and any number of times of transmission.

Now, a format of transmitting visible light signals by control signals such as illustrated in Fig. 7A, and a format of transmitting visible light signals by drive signals such as illustrated in Fig. 9A, will be described in comparison.

In the format illustrated in Fig. 7A, visible light signals (light ID) can be transmitted without breakdown of the picture display (gradation) by correction of picture gradient. However, the duty ratio of the light ID is set to the same ratio to each LED (equivalent to pixel) that transmits visible light signals. Note that the LEDs that transmit the visible light signals each are LEDs included in the same line out of the COM1 line, COM2 line, and COM3 line. The lower the duty ratio of the light ID (first gradient) is made to be, visible light signals can be transmitted from LEDs with even lower picture gradients, but the luminance of the light ID decreases. On the other hand, the higher the duty ratio of the light ID (first gradient) is made to be, decreased luminance of the light ID can be suppressed, but it becomes difficult to transmit visible light signals from LEDs with low picture gradients.

In the format illustrated in Fig. 9A, the duty ratio can be set for each pixel. Accordingly, visible light signals can be transmitted even from LEDs with low picture gradients, while suppressing luminance from decreasing. That is to say, LEDs (pixels) with low picture gradient can transmit visible light signals (light ID) with a low duty ratio, and LEDs with high picture gradient can transmit visible light signals with a high duty ratio. The picture gradient (luminance) is corrected by an amount equivalent to the gradient of the light ID during the picture signal lit period. Thus, controlling the light ID gradient and picture gradient enables visible light signals to be transmitted from LEDs with low picture gradients while suppressing luminance from decreasing, by setting the duty ratio for pixels with a high picture gradient to be high during the light ID lit period.

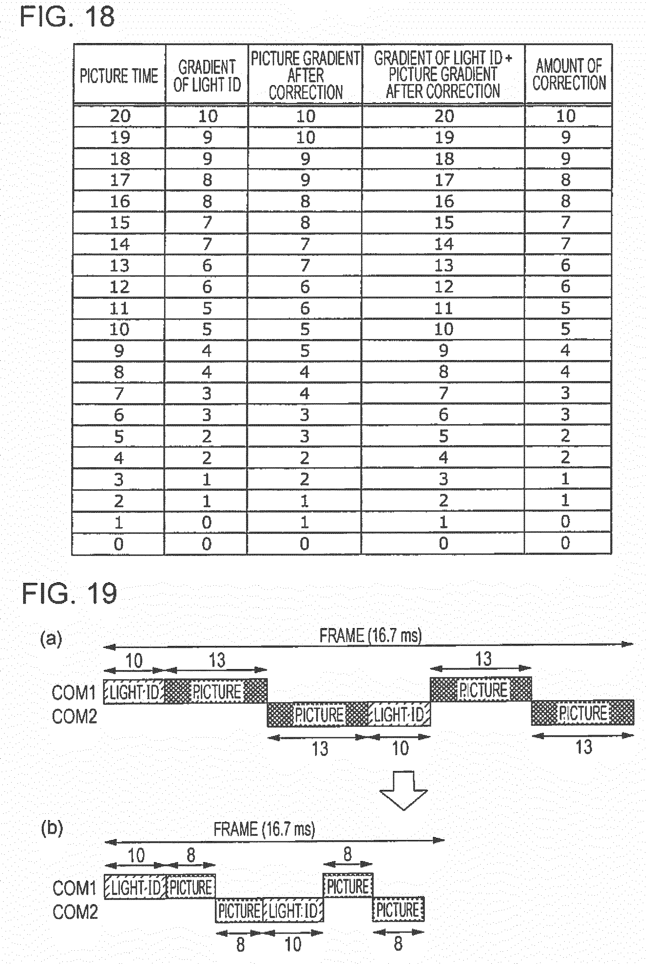

Fig. 18 is a diagram illustrating the relation between picture gradient, gradient of light ID, and picture gradient after correction, in a case where maximum picture gradient is 20.

For example, if the picture gradient is 20 and the light ID gradient (equivalent to duty ratio) is 10, the amount of correction as to the picture gradient is 10, and the picture gradient after correction is 20 - 10 = 10, as illustrated in this Fig. 18. At this time, the sum of the light ID gradient and the picture gradient after correction is 20, so the picture can be appropriately displayed, without breakdown of the original picture gradient of 20.

Now, wasteful periods may be reduced from the picture signal lit period. This enables decrease in luminance to be maximally suppressed.

Fig. 19 is a diagram illustrating an example of reduction of wasteful periods from the picture signal lit period.

For example, in a case where the maximum picture gradient is 26, and periods equivalent to 26 gradients are secured for the picture signal lit period, the light ID gradients (e.g., 10 gradients) are wasted, as illustrated in (a) in Fig. 19. That is to say, in a case where there are 10 gradients for the light ID, the picture gradients after correction will be 16 or lower, so it is sufficient to have periods equivalent to 16 gradients for the picture signal lit period. As a result, even if a picture signal lit period is a period equivalent to 26 gradients, 10 gradients worth of periods are wasted.

Accordingly, having the picture signal lit period to be a period equivalent to 16 gradients enables waste to be eliminated, as illustrated in (b) in Fig. 19. Note that the greatest duty ratio for the light ID is less than 100% (the greatest duty ration is 75% in the case of 4PPM), so there is reduction in luminance correspondingly, but this reduction can be minimized.

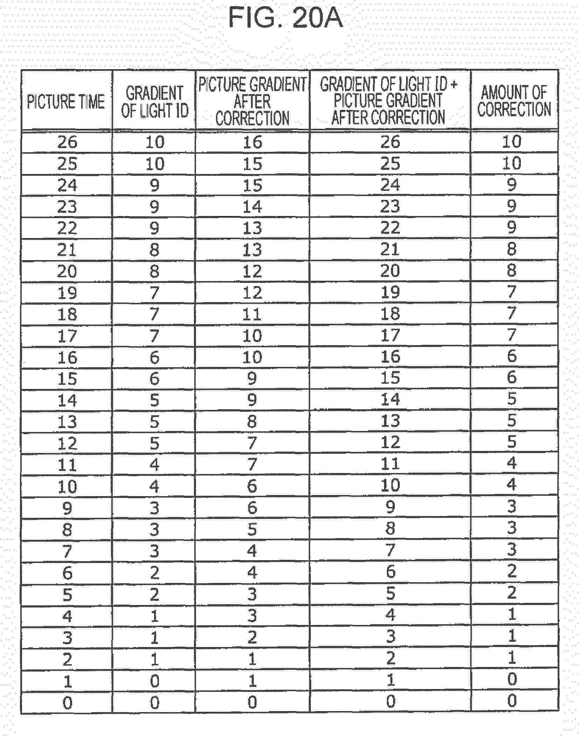

Fig. 20A through Fig. 20C are diagrams illustrating the relation between picture gradient, gradient of light ID, and picture gradient after correction, in a case where maximum picture gradient is 26.

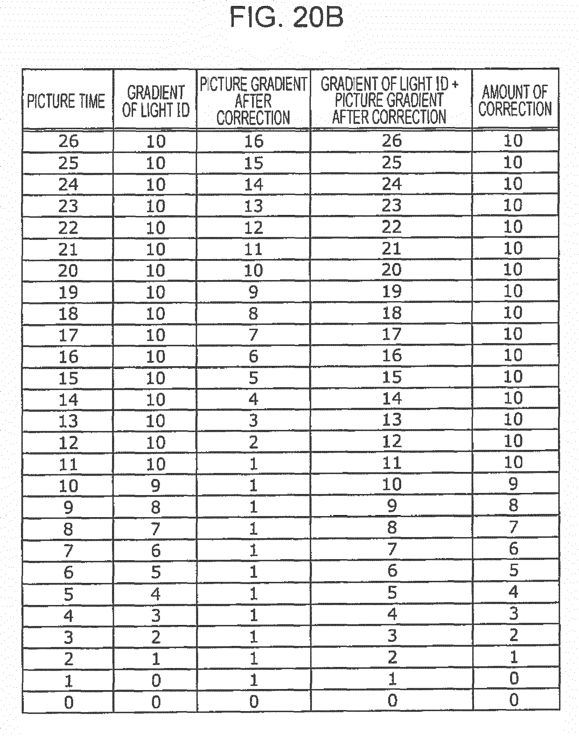

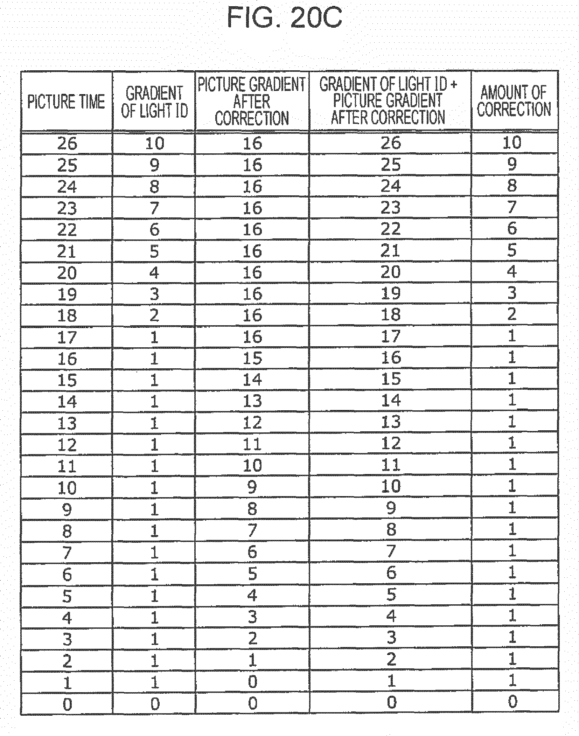

In the relation illustrated in Fig. 20A, the light ID gradient and picture gradient after correction change in the same way in accordance with increase and decrease in the picture gradient, in the same way as the relation illustrated in Fig. 18. In the relation illustrated in Fig. 20B, in a case of the picture gradient increasing from 0 to 26, the light ID gradient increases with priority. For example, between picture gradient 0 through 11, the light ID gradient increases along with the increase in picture gradient. Once the light ID gradient reaches the maximum which is 10, i.e., once the duty ration of the light ID is maximum, the picture gradient after correction increases from picture gradient 12 to 26 in accordance with the increase in picture gradient. In the relation illustrated in Fig. 20C, in a case of the picture gradient increasing from 0 to 26, the light picture gradient after correction increases with priority, the opposite of the relation illustrated in Fig. 20B. For example, between picture gradient 0 through 17, the picture gradient after correction increases along with increase in the original picture gradient. Upon the picture gradient after correction reaching 16 which is the maximum, the light ID gradient increases along with the increase in picture gradient from picture gradient 17 through 26.

### (In Closing)

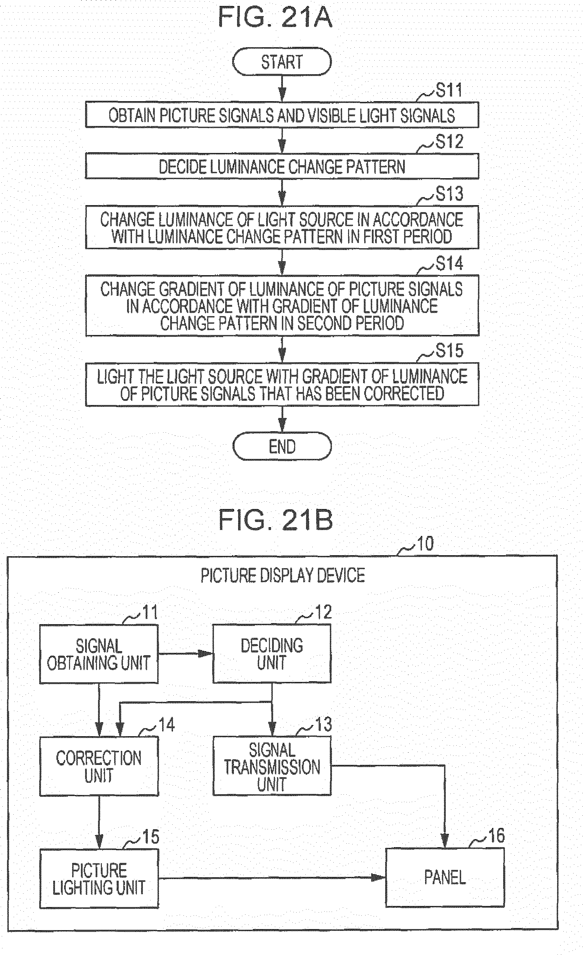

Fig. 21A is a flowchart illustrating the picture display method according to an aspect of the present disclosure.

The picture display method according to an aspect of the present disclosure includes steps S11 through S15. In step S11, picture signals and visible light signals are obtained. In step S12, a luminance change pattern is decided by modulating visible light signals. In step S13, the visible light signals are transmitted by causing luminance change of at least one light source out of multiple light sources included in a panel in accordance with the luminance change pattern, in a first period that is a partial period of a frame display period in which one frame of the picture signals is displayed.

In step S14, a second gradient, which is a gradient of luminance of the light source indicated by the picture signals, is corrected in accordance with a first gradient that is a gradient of luminance of the light source expressed by the luminance change pattern of the first period, in a second period that is a partial period of the frame display period and follows the first period. In step S15, the light source is lit at the corrected second gradient in the second period.

Fig. 21B is a diagram illustrating an example of the functional configuration of the picture display device according to an aspect of the present disclosure.

A picture display device 10 according to an aspect of the present disclosure is equivalent to the picture display device 100 in the above-described embodiment, and includes a panel 16, a signal obtaining unit 11, a deciding unit 12, a signal transmitting unit 13, a correcting unit 14, and a picture lighting unit 15.

The panel 16 has multiple light sources arrayed. The signal obtaining unit 11 obtains picture signals and visible light signals. The deciding unit 12 modulates the visible light signals to decide a luminance change pattern.

The signal transmitting unit 13 transmits the visible light signals by causing luminance change of at least one light source out of the multiple light sources included in the panel 16 in accordance with the luminance change pattern, in a first period that is a partial period of a frame display period in which one frame of the picture signals is displayed.

The correcting unit 14 corrects a second gradient, which is a gradient of luminance of the light source indicated by the picture signals, in accordance with a first gradient that is a gradient of luminance of the light source expressed by the luminance change pattern of the first period, in a second period that is a partial period of the frame display period and follows the first period. The picture lighting unit 15 lights the light source at the corrected second gradient in the second period.

The panel 16 here is the LED panel 130 for example, and the light sources are LEDs, for example. The light sources may be light sources that are different from LEDs, as long as pixels of pictures can be expressed. Also, the first period is the light ID lit period for example, and the second period is the picture signal lit period for example. The first gradient is equivalent to the above-described light ID gradient or correction gradient for example, and the second gradient is equivalent to the above-described picture gradient for example.

The signal obtaining unit 11 has the functions of each of the light ID control unit 150 and the LED driver circuit 140 for example, and executes processing of step S11 in Fig. 21A. The deciding unit 12 has the functions of the light ID control unit 150 for example, and executes the processing of step S12 in Fig. 21A. The signal transmitting unit 13 has the functions of the LED driver circuit 140 for example, and executes processing of step S13 in Fig. 21A. The correcting unit 14 has the functions of each of the light ID control unit 150 and the LED driver circuit 140 for example, and executes processing of step S14 in Fig. 21A. The picture lighting unit 15 has the functions of the LED driver circuit 140 for example, and executes processing of step S15 in Fig. 21A.

Thus, in the picture display method and picture display device 10 according to an aspect of the present disclosure, the second gradient is corrected in accordance with the first gradient, and when displaying a picture, the light sources are lit at the corrected second gradient. Accordingly, breakdown of the picture display can be suppressed. As a result, display of pictures and transmission of visible light signals can each be appropriately performed.

While a picture display method and picture display device according to one or multiple aspects of the present disclosure have been described by way of embodiments, the present disclosure is not restricted to these embodiments. Forms that are constructed by various modifications to the embodiments and combinations of components, which are conceivable by one skilled in the art, may be encompassed by one or multiple aspects without departing from the essence of the present disclosure.

The components in the above-described embodiments may be configured of dedicated hardware, or may be realized by executing software programs appropriate for the components. The components may be realized by a program executing unit such as a CPU or processor or the like reading out and executing software programs recorded in recording media such as a hard disk or semiconductor memory or the like. Now, software that realizes the picture display device and so forth according to the above-described embodiment is a program that causes a computer to execute the steps included in the flowchart in Fig. 21A.

### Industrial Applicability

The present disclosure is advantageous in that display of pictures and transmission of visible light signals can each be appropriately performed, and is applicable to a picture display device having a large-size LED panel, for example. Reference Signs List

1 through 9 LEDs
100 picture display device
110 time-division switching control unit
120 switch circuit
130 LED panel
140 LED driver circuit
150 light ID control unit
Tr1 through Tr3 transistors

## Claims

1. A picture display method comprising:
a signal obtaining step of obtaining picture signals and visible light signals;
a deciding step of deciding a luminance change pattern by modulating the visible light signals;
a signal transmitting step of transmitting the visible light signals by performing luminance change of at least one light source out of a plurality of light sources included in a panel in accordance with the luminance change pattern, in a first period that is a partial period of a frame display period in which one frame of the picture signals is displayed;
a correcting step of correcting a second gradient, which is a gradient of luminance of the light source indicated by the picture signals, in accordance with a first gradient that is a gradient of luminance of the light source expressed by the luminance change pattern of the first period, in a second period that is a partial period of the frame display period and follows the first period; and
a picture lighting step of lighting the light source at the corrected second gradient in the second period.

2. The picture display method according to Claim 1,
wherein, in the signal transmitting step, out of the plurality of light sources included in the panel, a light source of which the second gradient indicated by the picture signal is lower than a threshold value gradient is not lit in the first period, and a light source of which the second gradient indicated by the picture signal is at the threshold value gradient or higher is caused to exhibit luminance change in the first period in accordance with the luminance change pattern.

3. The picture display method according to Claim 2,
wherein the gradient of luminance of each light source included in the panel is expressed in accordance with a lighting period over which the light source is lit,
wherein, in the correcting step, the second gradient is corrected by shortening the lighting period corresponding to the second gradient by a period corresponding to a lighting period corresponding to the first gradient,
and wherein in the picture lighting step, in the second period, the light source is lit for a lighting period corresponding to the shortened second gradient.

4. The picture display method according to Claim 3,
wherein, in the signal transmitting step, the light source is caused to exhibit luminance change in accordance with the luminance change pattern by being lit at one of a first luminance and a second luminance that are different from each other, in increments of slots, during the first period,
and wherein, when lighting the light source at the first luminance or the second luminance in the slot, the light source is lit for a period of the slot by causing the light source to repeatedly generate pulse light of a time width shorter than the slot.

5. The picture display method according to either Claim 3 or 4,
wherein the threshold value gradient is higher than the first gradient.

6. The picture display method according to Claim 5,
wherein the threshold value gradient is 1.5 times the first gradient.

7. The picture display method according to either Claim 5 or 6,
wherein, in the correcting step, in a case the light source being lit at multiple points in time in the second period, the second gradient is corrected at each of the plurality of points in time,
and wherein, in the picture lighting step, the light source is lit at the corrected second gradient at each of the plurality of points in time.

8. The picture display method according to Claim 7,
wherein, in the correcting step, the second gradient is corrected at each of the plurality of points in time by subtracting the same gradient from the second gradient at each of the plurality of points in time.

9. The picture display method step according to Claim 7,
wherein, in the correcting step, the second gradient is corrected at a first point in time and a second point in time out of the plurality of points in time, by subtracting n gradients (where n is an integer of 1 or greater) from the second gradient at the first point in time out of the plurality of points in time, and subtracting m gradients (where m is an integer of 1 or greater but smaller than n) from the second gradient at the second point in time that is farther from the first period than the first point in time.

10. A picture display device comprising:
a panel where a plurality of light sources are arrayed;
a signal obtaining unit that obtains picture signals and visible light signals;
a deciding unit that decides a luminance change pattern by modulating the visible light signals;
a signal transmitting unit that transmits the visible light signals by performing luminance change of at least one light source out of a plurality of light sources included in the panel in accordance with the luminance change pattern, in a first period that is a partial period of a frame display period in which one frame of the picture signals is displayed;
a correcting unit that corrects a second gradient, which is a gradient of luminance of the light source indicated by the picture signals, in accordance with a first gradient that is a gradient of luminance of the light source expressed by the luminance change pattern of the first period, in a second period that is a partial period of the frame display period and follows the first period; and
a picture lighting unit that lights the light source at the corrected second gradient in the second period.
